# EUROPEAN PATENT APPLICATION

(11) **EP 4 553 908 A1**
(43) Date of publication of application: **14.05.2025**
(21) Application number: 23835636.4
(22) Date of filing: 23.02.2023
(51) Int. Cl.: H01L 33/44, H01L 33/36, H01L 33/32, H01L 33/00, H01L 27/15, H01L 25/065, H01L 27/12

(54) **LIGHT-EMITTING ELEMENT, PIXEL COMPRISING SAME, AND METHOD FOR MANUFACTURING LIGHT-EMITTING ELEMENT**

(30) Priority: 07.07.2022 KR 20220083966
(71) Applicant: Samsung Display Co., Ltd., Yongin-si, Gyeonggi-do 17113 (KR)
(72) Inventor: PARK, Jeong Su, Yongin-si, Gyeonggi-do 17113 (KR); MIN, Jun Seok, Yongin-si, Gyeonggi-do 17113 (KR); LEE, Jong Chan, Yongin-si, Gyeonggi-do 17113 (KR)
(74) Representative: Marks & Clerk LLP
(86) International application number: PCT/KR2023/002614
(87) International publication number: WO 2024/010166

(57) **Abstract**

A light emitting element includes a first light emitting element including a first semiconductor layer, an active layer, and a second semiconductor layer, which are sequentially disposed in a first direction; a second light emitting element including a first semiconductor layer, an active layer, and a second semiconductor layer, which are spaced apart from the first light emitting element and sequentially disposed in a reverse direction of the first direction; and an insulative film surrounding a portion of the first light emitting element and a portion of the second light emitting element.

## Description

### Technical Field

The present disclosure generally relates to a light emitting element, a pixel including the same, and a manufacturing method of a light emitting element.

### Background Art

Recently, as interest in information displays is increased, research and development of display devices have been continuously conducted.

### Detailed Description of Invention

### Technical Problem

Embodiments provide a light emitting element capable of serving as an effective light source in a pixel regardless of the design of the pixel.

Embodiments also provide a pixel including the light emitting element and a manufacturing method of the light emitting element.

However, the purpose of the present invention is not limited to the above-mentioned purposes, and may be expanded in various ways without departing from the spirits and the scope of the present invention.

### Technical Solution

In accordance with an aspect of the disclosure, a light emitting element may include a first light emitting element including a first semiconductor layer, an active layer, and a second semiconductor layer, which are sequentially disposed in a first direction, a second light emitting element including a first semiconductor layer, an active layer, and a second semiconductor layer, which are spaced apart from the first light emitting element and sequentially disposed in a reverse direction of the first direction, and an insulative film surrounding a portion of the first light emitting element and a portion of the second light emitting element.

The insulative film may surround at least a portion of an outer circumferential surface of the first light emitting element and at least a portion of an outer circumferential surface of the second light emitting element, and fill a space between the first light emitting element and the second light emitting element.

The insulative film may include a first insulative film surrounding at least a portion of the outer circumferential surface of the first light emitting element and a second insulative film which surrounds at least a portion of the outer circumferential surface of the second light emitting element and fills the space between the first light emitting element and the second light emitting element.

The first insulative film and the second insulative film may include a same material.

The light emitting element may further include an electrode layer disposed on the second semiconductor layer of the first light emitting element and the second semiconductor layer of the second light emitting element.

Each of the first light emitting element and the second light emitting element may include a first end portion and a second end portion. Each of the electrode layer may be disposed on the first end portion of each of the first light emitting element and the second light emitting element, respectively, and each of the first semiconductor layer may be disposed at the second end portion of each of the first light emitting element and the second light emitting element, respectively.

The insulative film may expose each of the first end portion and the second end portion of each of the first light emitting element and the second light emitting element.

The first end portion of the first light emitting element and the second end portion of the second light emitting element may be disposed on a same plane.

The second light emitting element may be spaced apart from the first light emitting element in a second direction intersecting the first direction.

Shapes of the first light emitting element and the second light emitting element may be same.

Each of the first semiconductor layer may include GaN doped with an n-type dopant, and each of the second semiconductor layer may include GaN doped with a p-type dopant.

In accordance with another aspect of the disclosure, a method of manufacturing a light emitting element may include forming an undoped semiconductor layer on a stack substrate including a first area and a second area, sequentially forming a first semiconductor layer, an active layer, a second semiconductor layer, and an electrode layer on the undoped semiconductor layer, forming a first stack structure in the first area by removing a portion of each of the first semiconductor layer, the active layer, the second semiconductor layer, and the electrode layer, which correspond to the second area, forming a first insulative film covering the first stack structure including the first semiconductor layer, the active layer, the second semiconductor layer, and the electrode layer; sequentially forming an electrode layer, a second semiconductor layer, an active layer, and a first semiconductor layer in the first area and the second area, forming a second stack structure by removing a portion of each of the first semiconductor layer, the active layer, the second semiconductor layer, and the electrode layer in the second area and on the first stack structure, and forming a second insulative film covering at least a portion of a side surface of the second stack structure.

The forming of the second insulative film may include forming the second insulative film on an entire area of the first area and the second area, and removing the second insulative film disposed on a top surface of the first stack structure and a top surface of the second stack structure.

The forming of the first insulative film may include forming the first insulative film on an entire area of the first area and the second area; and removing the first insulative film of the second area.

The second semiconductor layer of the first stack structure and the first semiconductor layer of the second stack structure may be disposed in a same plane.

The forming of the second stack structure may include removing the first insulative film formed on the electrode layer of the first stack structure.

The method may further include forming a light emitting stack pattern by separating the first stack structure, the second stack structure, the first insulative film, and the second insulative film from the stack substrate and the undoped semiconductor layer.

The forming of the second stack structure may include forming two second stack structures in the second area.

In accordance with still another aspect of the disclosure, a pixel may include a first pixel electrode and a second pixel electrode, each disposed on a substrate, light emitting elements disposed on the first pixel electrode and the second pixel electrode, a first contact electrode electrically connecting the first pixel electrode and the light emitting elements to each other, and a second contact electrode electrically connecting the second pixel electrode and the light emitting elements to each other. Each of the light emitting elements may include a first light emitting element arranged in a first direction, a second light emitting element arranged in a second direction that is a reverse direction of the first direction, and an insulative film coupling the first light emitting element and the second light emitting element.

The first light emitting element may include a first semiconductor layer, an active layer, a second semiconductor layer, and an electrode layer, which are sequentially disposed in the first direction. The second light emitting element may include a first semiconductor layer, an active layer, a second semiconductor layer, and an electrode layer, which are sequentially disposed in the second direction.

Each of the first light emitting element and the second light emitting element may include a first end portion and a second end portion. Each of the electrode layer may be disposed on the first end portion of each of the first light emitting element and the second light emitting element, respectively, and each of the first semiconductor layer may be disposed at the second end portion of each of the first light emitting element and the second light emitting element, respectively.

The first end portion of the first light emitting element and the second end portion of the second light emitting element may electrically contact the first contact electrode, and the second end portion of the first light emitting element and the first end portion of the second light emitting element may be electrically contact the second contact electrode.

### Advantageous Effects

In the light emitting element and the pixel including the same in accordance with the present disclosure, one of a first light emitting element disposed in a first direction and a second light emitting element disposed in the reverse direction of the first direction, which are included in the light emitting element, can be provided as an effective light source. Thus, effective light sources of which number is equal to or greater than a predetermined reference in the pixel can be sufficiently secured. In addition, effective light sources of pixels can be uniformly secured.

However, the effects of the present invention are not limited to the effected described above, and may be expanded in various ways without departing from the sprits and the scope of the present invention.

### Description of Drawings

Embodiments will now be described more fully hereinafter with reference to the accompanying drawings; however, they may be embodied in different forms and should not be construed as limited to the embodiments set forth herein. Rather, these embodiments are provided so that this disclosure will be more thorough and complete, and will fully convey the scope of the embodiments to those skilled in the art.

In the drawing figures, dimensions may be exaggerated for clarity of illustration. It will be understood that when an element is referred to as being "between" two elements, it can be the only element between the two elements, or one or more intervening elements may also be present. Like reference numerals refer to like elements throughout.
FIG. 1 is a perspective view illustrating a light emitting element in accordance with embodiments of the disclosure.
FIG. 2 is a schematic cross-sectional view illustrating an embodiment of the light emitting element shown in FIG. 1.
FIG. 3 is a schematic plan view illustrating a display device in accordance with embodiments of the disclosure.
FIG. 4 is a schematic diagram of an equivalent circuit of a pixel included in the display device shown in FIG. 3.
FIG. 5 is a schematic plan view illustrating an embodiment of the pixel included in the display device shown in FIG. 3.
FIG. 6 is a cross-schematic sectional view illustrating an embodiment taken along line I-I' shown in FIG. 5.
FIGS. 7 to 21 are schematic cross-sectional views illustrating a manufacturing method of the light emitting element in accordance with embodiments of the disclosure.
FIGS. 22 to 26 are schematic cross-sectional views illustrating a manufacturing method of the display device in accordance with embodiments of the disclosure.

### Modes of the Invention

Hereinafter, preferred embodiments of the disclosure will be described in more detail with reference to the accompanying drawings. Throughout the drawings, the same reference numerals are given to the same elements, and their overlapping descriptions will be omitted.

When an element, such as a layer, is referred to as being "on", "connected to", or "coupled to" another element or layer, it may be directly on, connected to, or coupled to the other element or layer or intervening elements or layers may be present. When, however, an element or layer is referred to as being "directly on", "directly connected to", or "directly coupled to" another element or layer, there are no intervening elements or layers present. To this end, the term "connected" may refer to physical, electrical, and/or fluid connection, with or without intervening elements. Also, when an element is referred to as being "in contact" or "contacted" or the like to another element, the element may be in "electrical contact" or in "physical contact" with another element; or in "indirect contact" or in "direct contact" with another element.

In the specification and the claims, the phrase "at least one of" is intended to include the meaning of "at least one selected from the group of" for the purpose of its meaning and interpretation. For example, "at least one of A and B" may be understood to mean "A, B, or A and B."

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

Spatially relative terms, such as "beneath", "below", "under", "lower", "above", "upper", "over", "higher", "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below", for example, can encompass both an orientation of above and below. Furthermore, the apparatus may be otherwise oriented (e.g., rotated 90 degrees or at other orientations), and, as such, the spatially relative descriptors used herein interpreted accordingly.

The terms "about" or "approximately" as used herein is inclusive of the stated value and means within an acceptable range of deviation for the particular value as determined by one of ordinary skill in the art, considering the measurement in question and the error associated with measurement of the particular quantity (for example, the limitations of the measurement system). For example, "about" may mean within one or more standard deviations, or within ± 30%, 20%, 10%, 5% of the stated value.

Unless otherwise defined or implied herein, all terms (including technical and scientific terms) used have the same meaning as commonly understood by those skilled in the art to which this disclosure pertains. It will be further understood that terms, such as those defined in commonly used dictionaries, should be interpreted as having a meaning that is consistent with their meaning in the context of the relevant art and should not be interpreted in an ideal or excessively formal sense unless clearly defined in the specification.

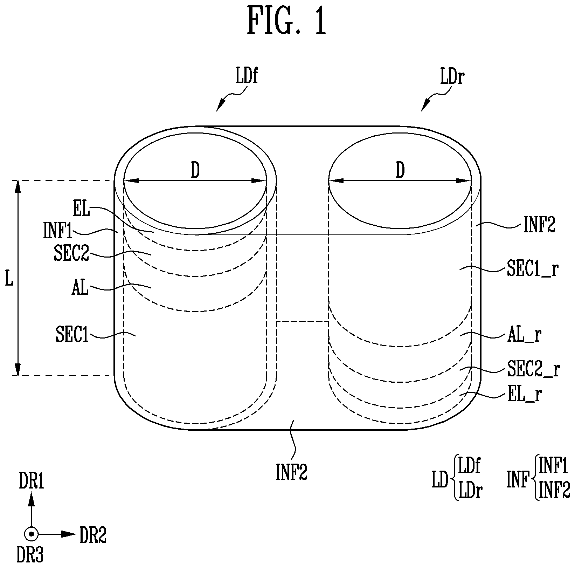

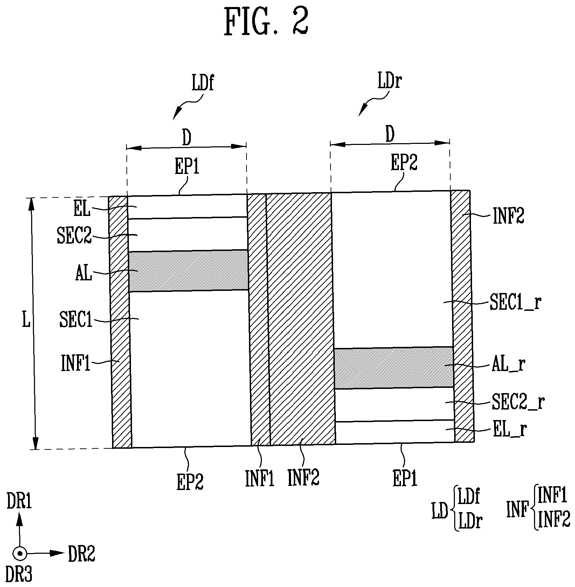

FIG. 1 is a perspective view illustrating a light emitting element in accordance with embodiments of the disclosure. FIG. 2 is a schematic cross-sectional view illustrating an embodiment of the light emitting element shown in FIG. 1.

Referring to FIGS. 1 and 2, the light emitting element LD may include a first light emitting element LDf and a second light emitting element LDr. For example, the light emitting element LD may include the first light emitting element LDf and the second light emitting element LDr, which extend in a first direction DR1. For example, the second light emitting element LDr may be disposed to be spaced apart from the first light emitting element LDf in a second direction DR2. For example, the light emitting element LD may be a unit in which the first light emitting element LDf and the second light emitting element LDr are integrally formed.

In an embodiment, the first light emitting element LDf may include a first semiconductor layer SEC1, a second semiconductor layer SEC2, an active layer AL, and an electrode layer EL. The second light emitting element LDr may include a first semiconductor layer SEC1_r, a second semiconductor layer SEC2_r, an active layer AL_r, and an electrode layer EL_r.

In an embodiment, the first light emitting element LDf may be implemented as a light emitting stack structure (or stack pattern) in which the first semiconductor layer SEC1, the active layer AL, the second semiconductor layer SEC2, and the electrode layer EL are sequentially stacked in the first direction DR1. The second light emitting element LDr may be implemented as a light emitting stack structure (or stack pattern) in which the first semiconductor layer SEC1_r, the active layer AL_r, the second semiconductor layer SEC2_r, and the electrode layer EL_r are sequentially stacked in the opposite direction of the first direction DR1.

In another embodiment, the electrode layer EL or EL_r may be omitted. In the first light emitting element LDf, the first semiconductor layer SEC1, the active layer AL, and the second semiconductor layer SEC2 may be sequentially stacked in the first direction DR1. In the second light emitting element LDr, the first semiconductor layer SEC1_r, the active layer AL_r, and the second semiconductor layer SEC2_r may be sequentially stacked in the reverse direction of the first direction DR1.

In an embodiment, the first light emitting element LDf of the light emitting element LD may be a forward light emitting element since the first semiconductor layer SEC1, the active layer AL, and the second semiconductor layer SEC2 are sequentially disposed along the first direction DR1. The second light emitting element LDr of the light emitting element LD may be a reverse light emitting element since the first semiconductor layer SEC1_r, the active layer AL_r, and the second semiconductor layer SEC2_r are sequentially disposed along the opposite direction (or reverse direction) of the first direction DR1.

In an embodiment, the first light emitting element LDf and the second light emitting element LDr may be symmetrical to each other in the second direction DR2. For example, the first light emitting element LDf may have an upside-down mirror image of the second light emitting element LDr. The first semiconductor layer SEC1, the active layer AL, the second semiconductor layer SEC2, and the electrode layer EL, which are included in the first light emitting element LDf, may be symmetrical to the first semiconductor layer SEC1_r, the active layer AL_r, the second semiconductor layer SEC2_r, and the electrode layer EL_r, which are included in the second light emitting element LDr, in the second direction DR2.

In an embodiment, the electrode layer EL of the first light emitting element LDf and the electrode layer EL_r of the second light emitting element LDr may be disposed in directions opposite to each other. For example, the first semiconductor layer SEC1 of the first light emitting element LDf and the first semiconductor layer SEC1_r of the second light emitting element LDr may be disposed in directions opposite to each other.

In an embodiment, the first light emitting element LDf and the second light emitting element LDr may be provided in a shape extending in the first direction DR1. In case that the extending direction of the first light emitting element LDf is a length direction, the first light emitting element LDf may include a first end portion EP1 and a second end portion EP2. The second light emitting element LDr may include a first end portion EP1 and a second end portion EP2.

In an embodiment, the electrode layer EL or EL_r may be disposed on the first end portion EP1 of each of the first light emitting element LDf and the second light emitting element LDr, and the first semiconductor layer SEC1 or SEC1_r may be disposed on the second end portion EP2 of each of the first light emitting element LDf and the second light emitting element LDr.

In an embodiment, the first end portion EP1 of the first light emitting element LDf and the second end portion EP2 of the second light emitting element LDr may be disposed in the same layer (plane). The second end portion EP2 of the first light emitting element LDf and the first end portion EP1 of the second light emitting element LDr may be disposed in the same layer (plane).

In an embodiment, the electrode layer EL or EL_r may be exposed on the first end portion EP1 of each of the first light emitting element LDf and the second light emitting element LDr. The first semiconductor layer SEC1 or SEC1_r may be exposed on the second end portion EP2 of each of the first light emitting element LDf and the second light emitting element LDr. For example, the electrode layer EL of the first light emitting element LDf and the first semiconductor layer SEC1_r of the second light emitting element LDr may be disposed in the same layer (plane). The first semiconductor layer SEC1 of the first light emitting element LDf and the electrode layer EL_r of the second light emitting element LDr may be disposed in the same layer (plane).

In an embodiment, the first semiconductor layer SEC1 of the first light emitting element LDf and the second semiconductor layer SEC2_r of the second light emitting element LDr may be disposed in the same layer (plane). The second semiconductor layer SEC2 of the first light emitting element LDf and the first semiconductor layer SEC1_r of the second light emitting element LDr may be disposed in the same layer (plane).

The first light emitting element LDf and the second light emitting element LDr may be provided in various shapes. In an embodiment, each of the first light emitting element LDf and the second light emitting element LDr may have a rod-like shape, a bar-like shape, a pillar-like shape, or the like, which is long in its length direction (i.e., its aspect ratio is greater than 1). In another embodiment, each of the first light emitting element LDf and the second light emitting element LDr may have a rod-like shape, a bar-like shape, a pillar-like shape, or the like, which is short in its length direction (i.e., its aspect ratio is smaller than 1). In still another embodiment, each of the first light emitting element LDf and the second light emitting element LDr may have a rod-like shape, a bar-like shape, a pillar-like shape, or the like, of which aspect ratio is 1.

In an embodiment, the first light emitting element LDf and the second light emitting element LDr may include, for example, a light emitting diode (LED) manufactured small enough to have a diameter D and/or a length L in a nano scale (or nanometers) or a micro scale (micrometers).

In an embodiment, in case that each of the first light emitting element LDf and the second light emitting element LDr is long in its length direction (i.e., its aspect ratio is greater than 1), the diameter D of each of the first light emitting element LDf and the second light emitting element LDr may be in a range of about 0.5 µm to about 6 µm, and the length L of each of the first light emitting element LDf and the second light emitting element LDr may be in a range of about 1 µm to about 10 µm. The aspect ratio of the light emitting element LD including the first light emitting element LDf and the second light emitting element LDr may be smaller than 1. However, the diameter D and the length L of each of the first light emitting element LDf and the second light emitting element LDr are not limited thereto, and the size of the light emitting element LD may be changed to accord with requirement conditions (or design conditions) of a lighting device or a self-luminous display device, to which the first light emitting element LDf and the second light emitting element LDr are applied.

In an embodiment, the first semiconductor layer SEC1 or SEC1_r may be a first conductivity type semiconductor layer. The first semiconductor layer SEC1 or SEC1_r may include at least one n-type semiconductor layer. The first semiconductor layer SEC1 or SEC1_r may include at least one semiconductor material such as InAlGaN, GaN, AlGaN, InGaN, AlN, and InN. The first semiconductor layer SEC1 or SEC1_r may be an n-type semiconductor layer doped with a first conductive dopant (or n-type dopant) such as silicon (Si), germanium (Ge) or tin (Sn). However, the material constituting the first semiconductor layer SEC1 or SEC1_r is not limited thereto. The first semiconductor layer SEC1 or SEC1_r may include various materials.

In an embodiment, the first semiconductor layer SEC1 may include an upper surface on which the active layer AL is disposed in the length direction of the first light emitting element LDf and a lower surface exposed to the outside in the opposite direction of the first direction DR1. The first semiconductor layer SEC1 may be an end portion (or bottom end portion) of the light emitting element LD.

In an embodiment, the first semiconductor layer SEC1_r may include a lower surface on which the active layer AL_r is disposed in the opposite direction of the length direction of the second light emitting element LDr and an upper surface exposed to the outside in the first direction DR1. The first semiconductor layer SEC1_r may be another end portion (or top end portion) of the light emitting element LD.

In an embodiment, the active layer AL or AL_r may be disposed between the first semiconductor layer SEC1 or SEC1_r and the second semiconductor layer SEC2 or SEC2_r, respectively. In an embodiment, the active layer AL of the first light emitting element LDf may be disposed between the first semiconductor layer SEC1 and the second semiconductor layer SEC2. The active layer AL_r of the second light emitting element LDr may be disposed between the first semiconductor layer SEC1_r and the second semiconductor layer SEC2_r. For example, the active layer AL or AL_r may be formed on the first semiconductor layer SEC1 or SEC1_r, and may be formed in a single or multiple quantum well structure. For example, in case that the active layer AL or AL_r is formed in a multiple quantum well structure, a barrier layer, a strain reinforcing layer, and a well layer, which constitute one unit, may be periodically and repeatedly stacked in the active layer AL or AL_r. The strain reinforcing layer may have a lattice constant smaller than that of the barrier layer, to reduce strain, e.g., compressive strain applied to the well layer. However, the structure of the active layer AL or AL_r is not limited to the above-described embodiment.

In an embodiment, the active layer AL or AL_r may emit light having a wavelength in a range of about 400 nm to about 900 nm, and use a double hetero structure. The active layer AL or AL_r may include a first surface in contact with the first semiconductor layer SEC1 or SEC1_r and a second surface in contact with the second semiconductor layer SEC2 or SEC2_r.

In an embodiment, the active layer AL of the first light emitting element LDf may include a lower surface in contact with the first semiconductor layer SEC1 and an upper surface in contact with the second semiconductor layer SEC2.

In an embodiment, the active layer AL_r of the second light emitting element LDr may include an upper surface in contact with the first semiconductor layer SEC1_r and a lower surface in contact with the second semiconductor layer SEC2_r.

In an embodiment, light may be emitted from the active layer AL of the first light emitting element LDf and/or the active layer AL_r of the second light emitting element LDr. A color (or light output color) of the light emitting element LD may be determined according to a wavelength of the light emitted from the active layer AL of the first light emitting element LDf and/or the active layer AL_r of the second light emitting element LDr. The color of the light emitting element LD may determine a color of a pixel corresponding thereto. For example, the light emitting element LD may emit red light, green light, or blue light through the active layer AL of the first light emitting element LDf and/or the active layer AL_r of the second light emitting element LDr.

In an embodiment, in case that an electric field having a predetermined (or selectable) voltage or more is applied to the end portions of each of the first light emitting element LDf and the second light emitting element LDr, electron-hole pairs may be combined in the active layer AL of the first light emitting element LDf and/or the active layer AL_r of the second light emitting element LDr, and the first light emitting element LDf and/or the second light emitting element LDr may emit light. The light emitting element LD including the first light emitting element LDf and the second light emitting element LDr may be used as a light source (or light emitting source) for various light emitting devices, including a pixel of a display device.

In an embodiment, the second semiconductor layer SEC2 or SEC2_r may include a second conductivity type semiconductor layer different from the first conductivity type semiconductor layer of the first semiconductor layer SEC1 or SEC1_r. The second semiconductor layer SEC2 or SEC2_r may include at least one p-type semiconductor layer. The second semiconductor layer SEC2 or SEC2_r may include at least one semiconductor material such as InAlGaN, GaN, AlGaN, InGaN, AlN, and InN, and include a p-type semiconductor layer doped with a second conductive dopant (or p-type dopant) such as magnesium (Mg), zinc (Zn), calcium (Ca), strontium (Sr) or barium (Ba). However, the material constituting the second semiconductor layer SEC2 or SEC2_r is not limited thereto. The second semiconductor layer SEC2 or SEC2_r may include various materials.

In an embodiment, the second semiconductor layer SEC2 may include a lower surface in contact with the second surface of the active layer AL in the length direction of the first light emitting element LDf and an upper surface in contact with the electrode layer EL.

In an embodiment, the second semiconductor layer SEC2_r may include an upper surface in contact with the second surface of the active layer AL_r in the opposite direction of the length direction of the first light emitting element LDf and a lower surface in contact with the electrode layer EL_r.

In an embodiment, the electrode layer EL or EL_r may include a metal or a conductive metal oxide. For example, the electrode layer EL or EL_r may include at least one of chromium (Cr), titanium (Ti), aluminium (Al), gold (Au), nickel (Ni), and any oxide or alloy thereof, a transparent electrode material such as indium tin oxide (ITO), indium zinc oxide (IZO), zinc oxide (ZnO), indium gallium zinc oxide (IGZO), or indium tin zinc oxide (ITZO), and the like. The electrode layer EL or EL_r may be substantially transparent. Accordingly, light generated in the first light emitting element LDf and/or the second light emitting element LDr may be emitted to the outside of the first light emitting element LDf and/or the second light emitting element LDr by transmitting through the electrode layer EL or EL_r.

In an embodiment, the electrode layer EL may include a lower surface on which the second semiconductor layer SEC2 is disposed, and an upper surface exposed to the outside in the first direction DR1. The electrode layer EL may be an end portion (or top end portion) of the light emitting element LD.

In an embodiment, the electrode layer EL_r may include an upper surface on which the second semiconductor layer SEC2_r is disposed, and a lower surface exposed to the outside in the opposite direction of the first direction DR1. The electrode layer EL_r may be another end portion (or bottom end portion) of the light emitting element LD.

In an embodiment, the first semiconductor layer SEC1 or SEC1_r and the second semiconductor layer SEC2 or SEC2_r may have different thicknesses in the length direction of the light emitting element LD. For example, the first semiconductor layer SEC1 or SEC1_r may have a thickness greater than a thickness of the second semiconductor layer SEC2 or SEC2_r. Accordingly, the active layer AL of the first light emitting element LDf may be disposed more adjacent to the upper surface of the second semiconductor layer SEC2 than the lower surface of the first semiconductor layer SEC1. The active layer AL_r of the second light emitting element LDr may be disposed more adjacent to the lower surface of the second semiconductor layer SEC2_r than the upper surface of the first semiconductor layer SEC1_r.

Although it is illustrated that each of the first semiconductor layer SEC1 or SEC1_r and the second semiconductor layer SEC2 or SEC2_r is configured with one layer in FIGS. 1 and 2, the disclosure is not limited thereto. In an embodiment, each of the first semiconductor layer SEC1 or SEC1_r and the second semiconductor layer SEC2 or SEC2_r may further include at least one layer, e.g., a clad layer and/or a Tensile Strain Barrier Reducing (TSBR) layer according to the material of the active layer AL or AL_r. The TSBR layer may be a strain reducing layer disposed between semiconductor layers having different lattice structures to perform a buffering function for reducing a lattice constant difference. The TSBR layer may be configured with a p-type semiconductor layer such as p-GAInP, p-AlInP or p-AlGaInP, but the disclosure is not limited thereto.

In an embodiment, an insulative film INF may surround outer circumferential surfaces of the first light emitting element LDf and the second light emitting element LDr. In an embodiment, the insulative film INF may surround a portion of the first light emitting element LDf and a portion of the second light emitting element LDr.

In an embodiment, the insulative film INF may include a first insulative film INF1 and a second insulative film INF2. For example, the first insulative film INF1 may surround outer circumferential surfaces of the first semiconductor layer SEC1, the active layer AL, the second semiconductor layer SEC2, and the electrode layer EL of the first light emitting element LDf. The second insulative film INF2 may surround outer circumferential surfaces of the first semiconductor layer SEC1_r, the active layer AL_r, the second semiconductor layer SEC2_r, and the electrode layer EL_r of the second light emitting element LDr. For example, the second insulative film INF2 may couple the first light emitting element LDf and the second light emitting element LDr.

In an embodiment, the insulative film INF may expose the first end portion EP1 and the second end portion EP2 of each of the first light emitting element LDf and the second light emitting element LDr.

In an embodiment, an area of the first semiconductor layer SEC1, which corresponds to the second end portion EP2, and an area of the electrode layer EL, which corresponds to the first end portion EP1, in the first light emitting element LDf may be exposed from the first insulative film INF1. An area of the first semiconductor layer SEC1_r, which corresponds to the second end portion EP2, and an area of the electrode layer EL_r, which corresponds to the first end portion EP1, in the second light emitting element LDr may be exposed from the second insulative film INF2.

In an embodiment, the insulative film INF may minimize a surface defect of the first light emitting element LDf and the second light emitting element LDr, thereby improving the lifetime and light emission efficiency of the first light emitting element LDf and the second light emitting element LDr. The insulative film INF may prevent an electrical short circuit which may occur in case that the active layer AL or AL_r is in contact with a conductive material except the first semiconductor layer SEC1 or SEC1_r and the second semiconductor layer SEC2 or SEC2_r.

It has been described that the insulative film INF entirely surrounds outer circumferential surfaces of the light emitting stack structures of the first light emitting element LDf and the second light emitting element LDr. However, the disclosure is not limited thereto.

In an embodiment, the insulative film INF may include a transparent insulating material. For example, the insulative film INF may include at least one insulating material selected from the group consisting of silicon oxide (SiOx), silicon nitride (SiNx), silicon oxynitride (SiOxNy), aluminium oxide (AlOx), titanium oxide (TiOx), hafnium oxide (HfOx), titanium strontium oxide (SrTiOx), cobalt oxide (CoxOy), magnesium oxide (MgO), zinc oxide (ZnO), ruthenium oxide (RuOx), nickel oxide (NiO), tungsten oxide (WOx), tantalum oxide (TaOx), gadolinium oxide (GdOx), zirconium oxide (ZrOx), gallium oxide (GaOx), vanadium oxide (VxOy), ZnO:Al, ZnO:B, InxOy:H, niobium oxide (NbxOy), magnesium fluoride (MgFx), aluminium fluoride (AlFx), Alucone polymer film, titanium nitride (TiN), tantalum nitride (TaN), aluminium nitride (AlNx), gallium nitride (GaN), tungsten nitride (WN), hafnium nitride (HfN), niobium nitride (NbN), gadolinium nitride (GdN), zirconium nitride (ZrN), vanadium nitride (VN), and the like. However, the disclosure is not limited thereto, and various materials having insulating properties may be used for the insulative film INF.

In an embodiment, the first insulative film INF1 and the second insulative film INF2 may be provided as a single layer or be provided as a multi-layer including at least two layers. For example, the first insulative film INF1 and the second insulative film INF2 may be formed with the same material. However, the disclosure is not limited thereto, and the first insulative film INF1 and the second insulative film INF2 may include different materials.

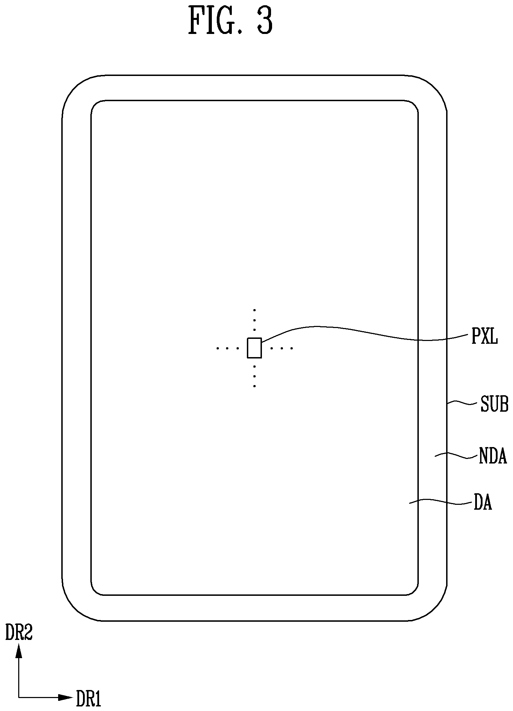

FIG. 3 is a schematic plan view illustrating a display device in accordance with embodiments of the disclosure.

In FIG. 3, for convenience of description, a structure of the display device is briefly illustrated based on a display area DA.

Referring to FIGS. 1 to 3, the display device may include a substrate SUB, multiple pixels PXL which are provided on the substrate SUB and each of which includes at least one light emitting element LD, a driving part which is provided on the substrate SUB and drives the pixels PXL, and a line unit which connects the pixels PXL to the driving part.

The substrate SUB may include a display area DA and a non-display area NDA.

The display area DA may be an area in which the pixels PXL for displaying an image are provided. The non-display area NDA may be an area in which the driving part for driving the pixels PXL and a portion of the line unit which connects the pixels PXL to the driving part are provided. For convenience, only one pixel PXL is illustrated in FIG. 3, but multiple pixels PXL may be provided in the display device DA of the substrate SUB.

The non-display area NDA may be disposed adjacent to the display area DA. The non-display area NDA may be disposed on at least one side of the display area DA. For example, the non-display area NDA may surround a circumference (or edge) of the display device DA. The line unit connected to the pixels PXL and a driving part which is connected to the line unit and drives the pixels PXL may be provided in the non-display area NDA.

The line unit may electrically connect the pixels PXL to the driving part. The line unit may include a fan-out line connected to signal lines, e.g., a scan line, a data line, an emission control line, and the like, which provide signals to each pixel PXL and are connected to each pixel PXL. In some embodiments, the line unit may include a fan-out line connected to signal lines, e.g., a control line, a sensing line, and the like, which are connected to each pixel PXL, to compensate for an electrical characteristic change of each pixel PXL in real time. The line unit may include a fan-out line connected to power lines which provide a voltage to each pixel PXL and are connected to each pixel PXL.

The substrate SUB may include a transparent insulating material to enable light to be transmitted therethrough. The substrate SUB may be a rigid substrate or a flexible substrate.

An area on the substrate SUB may be provided as the display area DA such that the pixels PXL are disposed therein, and another area on the substrate SUB may be provided as the non-display area NDA. For example, the substrate SUB may include a display area DA including pixel areas in which the pixels PXL are disposed and a non-display area NDA disposed at the periphery of the display area DA (or adjacent to the display area DA).

Each of the pixels PXL may be provided in the display area DA on the substrate SUB. In an embodiment, the pixels PXL may be arranged in a stripe arrangement structure or a PENTILE^{™} arrangement structure in the display area DA, but the disclosure is not limited thereto.

Each pixel PXL may include at least one light emitting element LD driven by a corresponding scan signal and a corresponding data signal. The light emitting element LD may have a small size to a degree of a nano scale (or nanometers) to a micro scale (micrometers), and be connected in parallel to light emitting elements disposed adjacent thereto. However, the disclosure is not limited thereto. The light emitting element LD may constitute a light source of each pixel PXL.

Each pixel PXL may include at least one light source, e.g., the light emitting element LD shown in FIGS. 1 and 2, which is driven by a signal (e.g., a scan signal, a data signal, and the like) and/or a power (e.g., a first driving power, a second driving power, and the like). However, the kind of light emitting element LD which may be used as the light source of each pixel PXL is not limited thereto.

The driving part may supply a signal and a power to each pixel PXL through the line unit, and accordingly, driving of the pixel PXL may be controlled.

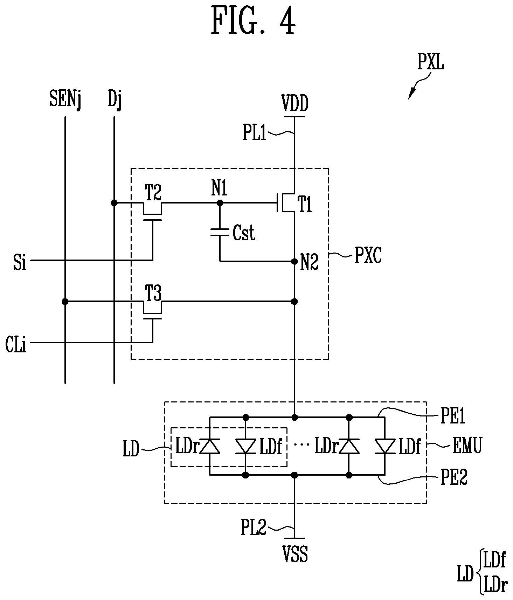

FIG. 4 is a schematic diagram of an equivalent circuit of the pixel included in the display device shown in FIG. 3.

Referring to FIG. 4, the pixel PXL may include a pixel circuit PXC and a light emitting unit EMU (or light emitting part).

In an embodiment, the pixel PXL may include a light emitting unit EMU (or light emitting part) which generates light with a luminance corresponding to a data signal. Also, the pixel PXL may include a pixel circuit PXC for driving the light emitting unit EMU.

In an embodiment, the light emitting unit EMU may include multiple light emitting elements LD connected in parallel between a first power line PL1 connected to a first driving power source VDD to be applied with a voltage of the first driving power source VDD and a second power line PL2 connected to a second driving power source VSS to be applied with a voltage of the second driving power source VSS. For example, the light emitting unit EMU may include a first pixel electrode PE1 connected to the first driving power source VDD via the pixel circuit PXC and the first power line PL1, a second pixel electrode PE2 connected to the second driving power source VSS through the second power line PL2, and multiple light emitting elements LD connected in parallel in the same direction between the first and second pixel electrodes PE1 and PE2. In an embodiment, the first pixel electrode PE1 may be an anode, and the second pixel electrode PE2 may be a cathode.

In an embodiment, each of the light emitting elements LD included in the light emitting unit EMU may be an integrated light emitting element unit including a first light emitting element LDf and a second light emitting element LDr.

In an embodiment, each of the first light emitting element LDf and the second light emitting element LDr, which are included in each of the light emitting elements LD included in the light emitting unit EMU, may include an end portion connected to the first driving power source VDD through the first pixel electrode PE1 and another end portion connected to the second driving power source VSS through the second pixel electrode PE2. The first driving power source VDD and the second driving power source VSS may have different potentials. For example, the first driving power source VDD may be a high-potential power source, and the second driving power source VSS may be a low-potential power source. A potential difference between the first and second driving power sources VDD and VSS may be equal to or higher than a threshold voltage of the light emitting elements LD during an emission period of the pixel PXL.

In an embodiment, one of the first light emitting element LDf and the second light emitting element LDr in the light emitting element LD may be connected in a forward direction between the first pixel electrode PE1 and the second pixel electrode PE2, and another one of the first light emitting element LDf and the second light emitting element LDr may be connected in a reverse direction between the first pixel electrode PE1 and the second pixel electrode PE2. Referring to FIG. 4, it is illustrated that the first light emitting element LDf of the light emitting element LD is connected in the forward direction between the first pixel electrode PE1 and the second pixel electrode PE2, and the second light emitting element LDr of the light emitting element LD is connected in the reverse direction between the first pixel electrode PE1 and the second pixel electrode PE2. However, the disclosure is not limited thereto, and some of the light emitting elements LD between the first pixel electrode PE1 and the second pixel electrode PE2 may have an arrangement in which the second light emitting element LDr is connected in the forward direction and the first light emitting element LDf is connected in the reverse direction.

In case that the first light emitting element LDf of the light emitting element LD is connected in the forward direction between the first pixel electrode PE1 and the second pixel electrode PE2 and the second light emitting element LDr of the light emitting element LD is connected in the reverse direction between the first pixel electrode PE1 and the second pixel electrode PE2, the first light emitting element LDf may become an effective (light emission) light source, and the second light emitting element LDr may become a non-effective (non-light emission) light source.

In an embodiment, in case that the light emitting element LD is provided in the pixel PXL, a number of light emitting elements forming effective light sources in the light emitting unit EMU and a number of light emitting elements forming non-effective light sources in the light emitting unit EMU may be equal to each other, since the light emitting element LD includes both an effective light source and a non-effective light source.

Since one of the first light emitting element LDf and the second light emitting element LDr is an effective light source, the light emitting element LD may emit light through one of the first light emitting element LDf and the second light emitting element LDr.

In an embodiment, the pixel circuit PXC may be connected to a scan line Si and a data line Dj of the pixel PXL. Also, the pixel circuit PXC may be connected to a control line CLi and a sensing line SENj of the pixel PXL. For example, in case that the pixel PXL is disposed on an ith row and a jth column of the display area DA, the pixel circuit PXC of the pixel PXL may be connected an ith scan line Si, a jth data line Dj, an ith control line CLi, and a jth sensing line SENj in the display area DA.

In an embodiment, the pixel circuit PXC may include first to third transistors T1 to T3 and a storage capacitor Cst.

In an embodiment, the first transistor T1 may be a driving transistor for controlling a driving current applied to the light emitting unit EMU, and may be connected between the first driving power source VDD and the light emitting unit EMU. For example, a first terminal of the first transistor T1 may be connected (or coupled) to the first driving power source VDD through the first power line PL1, a second terminal of the first transistor T1 may be connected to a second node N2, and a gate electrode of the first transistor T1 may be connected to a first node N1. The first transistor T1 may control an amount of driving current applied to the light emitting unit EMU through the second node N2 from the first driving power source VDD according to a voltage applied to the first node N1. In an embodiment, the first terminal of the first transistor T1 may be a drain electrode, and the second terminal of the first transistor T1 may be a source electrode. However, the disclosure is not limited thereto. In some embodiments, the first terminal may be the source electrode, and the second terminal may be the drain electrode.

In an embodiment, the second transistor T2 may be a switching transistor which selects a pixel PXL in response to a scan signal and activates the pixel PXL, and may be connected between the data line Dj and the first node N1. A first terminal of the second transistor T2 may be connected to the data line Dj, a second terminal of the second transistor T2 may be connected to the first node N1, and a gate electrode of the second transistor T2 may be connected to the scan line Si. The first terminal and the second terminal of the second transistor T2 may be different terminals. For example, in case that the first terminal is a drain electrode, the second terminal may be a source electrode.

The second transistor T2 may be turned on in case that a scan signal having a gate-on voltage (e.g., a high level voltage) is supplied from the scan line Si, to electrically connect the data line Dj and the first node N1 to each other. The first node N1 may be a point at which the second terminal of the second transistor T2 and the gate electrode of the first transistor T1 are connected to each other, and the second transistor T2 may transfer a data signal to the gate electrode of the first transistor T1.

In an embodiment, the third transistor T3 may connect the first transistor T1 to the sensing line SENj, to acquire a sensing signal through the sensing line SENj and to detect a characteristic of the pixel PXL, including a threshold voltage of the first transistor, or the like, by using the sensing signal. Information on the characteristic of the pixel PXL may be used to convert image data such that a characteristic deviation between pixels PXL can be compensated. A second terminal of the third transistor T3 may be connected to the second terminal of the first transistor T1, a first terminal of the third transistor T3 may be connected to the sensing line SENj, and a gate electrode of the third transistor T3 may be connected to the control line CLi.

In an embodiment, the first terminal of the third transistor T3 may be connected to an initialization power source. The third transistor T3 may be an initialization transistor capable of initializing the second node N2. The third transistor T3 may be turned on in case that a control signal is supplied from the control line CLi, to transfer a voltage of the initialization power source to the second node N2. Accordingly, a second capacitor electrode of the storage capacitor Cst, which is connected to the second node N2, may be initialized.

In an embodiment, a first capacitor electrode of the storage capacitor Cst may be connected to the first node N1, and the second capacitor electrode of the storage capacitor Cst may be connected to the second node N2. The storage capacitor Cst may charge a data voltage corresponding to the data signal supplied to the first node N1 during one frame period. Accordingly, the storage capacitor Cst may store a voltage corresponding to the difference between a voltage of the gate electrode of the first transistor T1 and a voltage of the second node N2.

Although an embodiment in which the light emitting elements LD constituting the light emitting unit EMU are all connected in parallel has been illustrated in FIG. 4, the disclosure is not limited thereto. In some embodiments, the light emitting unit EMU may be configured to include at least one serial stage (or stage) including multiple light emitting elements LD connected in parallel to each other. For example, the light emitting unit EMU may be configured as a series/parallel hybrid structure.

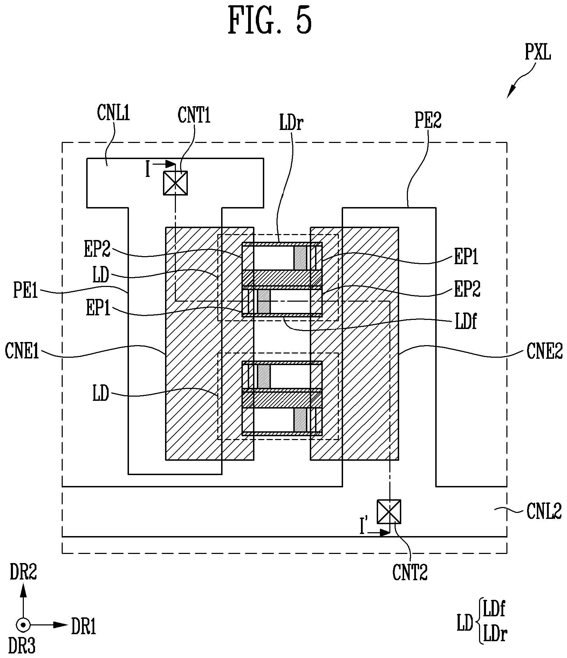

FIG. 5 is a schematic plan view illustrating an embodiment of the pixel included in the display device shown in FIG. 3.

FIG. 5 is a view illustrating some components included in the pixel PXL.

Referring to FIG. 5, the display device may include a first pixel electrode PE1, a second pixel electrode PE2, a first connection electrode CNL1, a second connection electrode CNL2, a first contact electrode CNE1, a second contact electrode CNE2, a first contact part CNT1, a second contact part CNT2, and a light emitting element LD to constitute a pixel PXL.

In an embodiment, a pixel PXL may include a first pixel electrode PE1 and a second pixel electrode PE2. For example, the first pixel electrode PE1 and the second pixel electrode PE2 may serve as electrodes for aligning the light emitting element LD and electrodes for applying a voltage.

In an embodiment, the first pixel electrode PE1 and the second pixel electrode PE2 may serve as alignment electrodes for the light emitting element LD including a first light emitting element LDf and a second light emitting element LDr. For example, the light emitting element LD may be arranged in response to an electrical signal provided from the first pixel electrode PE1 and the second pixel electrode PE2.

In an embodiment, the light emitting element LD may be a light emitting element unit including the first light emitting element LDf and the second light emitting element LDr, and multiple light emitting elements LD may be arranged. For example, multiple light emitting elements LD may be arranged in a parallel in the second direction DR2. However, the arrangement structure of the light emitting element LD is not limited thereto.

In an embodiment, the light emitting element LD may be disposed between the first pixel electrode PE1 and the second pixel electrode PE2 in a plan view. The light emitting element LD may be disposed on the first pixel electrode PE1 and the second pixel electrode PE2.

In an embodiment, the first light emitting element LDf and the second light emitting element LDr of the light emitting element LD may be electrically connected to the first pixel electrode PE1 through the first contact electrode CNE1.

In an embodiment, a first end portion EP1 of the first light emitting element LDf and a second end portion EP2 of the second light emitting element LDr may be electrically connected to the first contact electrode CNE1. A second semiconductor layer SEC2 of the first light emitting element LDf and a first semiconductor layer SEC1_r of the second light emitting element LDr may be electrically connected to the first contact electrode CNE1.

In an embodiment, the first light emitting element LDf and the second light emitting element LDr of the light emitting element LD may be electrically connected to the second pixel electrode PE2 through the second contact electrode CNE2.

In an embodiment, a second end portion EP2 of the first light emitting element LDf and a first end portion EP1 of the second light emitting element LDr may be electrically connected to the second contact electrode CNE2. A first semiconductor layer SEC1 of the first light emitting element LDf and a second semiconductor layer SEC2_r of the second light emitting element LDr may be electrically connected to the second contact electrode CNE2.

In an embodiment, the first pixel electrode PE1 and the second pixel electrode PE2 may be electrically connected to the pixel circuit PXC and/or a power line. For example, the first pixel electrode PE1 may be electrically connected to the pixel circuit PXC and/or the first power line PL1 through a first contact part CNT1 formed in the first connection electrode CNL1, and the second pixel electrode PE2 may be electrically connected to the second power line PL2 through a second contact part CNT2 formed in the second connection electrode CNL2.

In an embodiment, each of the first semiconductor layers SEC1 and SEC1_r of the first light emitting element LDf and the second light emitting element LDr may be an n-type conductive semiconductor layer, and the second semiconductor layer SEC2 and SEC2_r of the first light emitting element LDf and the second light emitting element LDr may be a p-type conductive semiconductor layer. in case that the light emitting element LDf or LDr is disposed between the first pixel electrode PE1 and the second pixel electrode PE2, the light emitting element LDf or LDr may be disposed in the forward direction in case that the second semiconductor layer SEC2 or SEC2_r of the light emitting element LDf or LDr is electrically connected to the first pixel electrode PE1 and the first semiconductor layer SEC1 or SEC1_r of the light emitting element LDf or LDr is electrically connected to the second pixel electrode PE2. Therefore, the corresponding light emitting element may correspond to a light emitting element forming an effective light source. On the contrary, in case that the first semiconductor layer SEC1 or SEC1_r of the light emitting element LDf or LDr is electrically connected to the first pixel electrode PE1 and the second semiconductor layer SEC2 or SEC2_r of the light emitting element LDf or LDr is electrically connected to the second pixel electrode PE2, the light emitting element LDf or LDr may be disposed in the reverse direction. Therefore, the corresponding light emitting element may correspond to a light emitting element forming a non-effective light source.

Referring to FIG. 5, in case that the light emitting elements LD are provided in the pixel PXL, one of the first light emitting element LDf and the second light emitting element LDr, which are included in the light emitting element LD, may be connected in the forward direction between the first pixel electrode PE1 and the second pixel electrode PE2, and another one of the first light emitting element LDf and the second light emitting element LDr may be connected in the reverse direction between the first pixel electrode PE1 and the second pixel electrode PE2. For example, the first light emitting element LDf may be disposed in the forward direction between the first pixel electrode PE1 and the second pixel electrode PE2, and the second light emitting element LDr may be disposed in the reverse direction between the first pixel electrode PE1 and the second pixel electrode PE2. For example, the first light emitting element LDf may form an effective light source, and the second light emitting element LDr may form a non-effective light source.

In another embodiment, in case that the first semiconductor layer SEC1 of the first light emitting element LDf of the light emitting element LD is electrically connected to the first pixel electrode PE1 and the second semiconductor layer SEC2 of the first light emitting element LDf is electrically connected to the second pixel electrode PE2, the first light emitting element LDf may form a non-effective light source. In case that the second semiconductor layer SEC2_r of the second light emitting element LDr is electrically connected to the first pixel electrode PE1 and the first semiconductor layer SEC1_r of the second light emitting element LDr is electrically connected to the second pixel electrode PE2, the second light emitting element LDr may form an effective light source.

In an embodiment, each of the light emitting elements LD provided in the pixel PXL may be provided as one light emitting element unit configured with a first light emitting element LDf disposed in the first direction DR1 and a second light emitting element LDr disposed in the reverse direction of the first direction DR1. Since one of the first light emitting element LDf and the second light emitting element LDr, which are included in the light emitting element LD, is disposed as an effective light source between the first pixel electrode PE1 and the second pixel electrode PE2, effective light sources of which number is equal to or greater than a reference in the pixel PXL may be sufficiently secured. Effective light sources of multiple pixels may be also uniformly secured.

In an embodiment, the first pixel electrode PE1 and the second pixel electrode PE2 may extend in the second direction DR2. The first pixel electrode PE1 and the second pixel electrode PE2 may be disposed to be spaced apart from each other in the first direction DR1.

In an embodiment, the first connection electrode CNL1 may be disposed in the same layer as the first pixel electrode PE1 to be integrally formed with the first pixel electrode PE1.

In an embodiment, the first contact electrode CNE1 may be disposed on the first pixel electrode PE1 in a cross-sectional view to be electrically connected to the first pixel electrode PE1. The first contact electrode CNE1 may electrically connect the first pixel electrode PE1 and the light emitting element LD to each other.

In an embodiment, the second contact electrode CNE2 may be disposed on the second pixel electrode PE2 in a cross-sectional view to be electrically connected to the second pixel electrode PE2. The second contact electrode CNE2 may electrically connect the second pixel electrode PE2 and the light emitting element LD to each other.

In an embodiment, the first contact electrode CNE1 may overlap the first end portion EP1 of the first light emitting element LDf and the second end portion EP2 of the second light emitting element LDr in a plan view.

In an embodiment, the second contact electrode CNE2 may overlap the second end portion EP2 of the first light emitting element LDf and the first end portion EP1 of the second light emitting element LDr in a plan view.

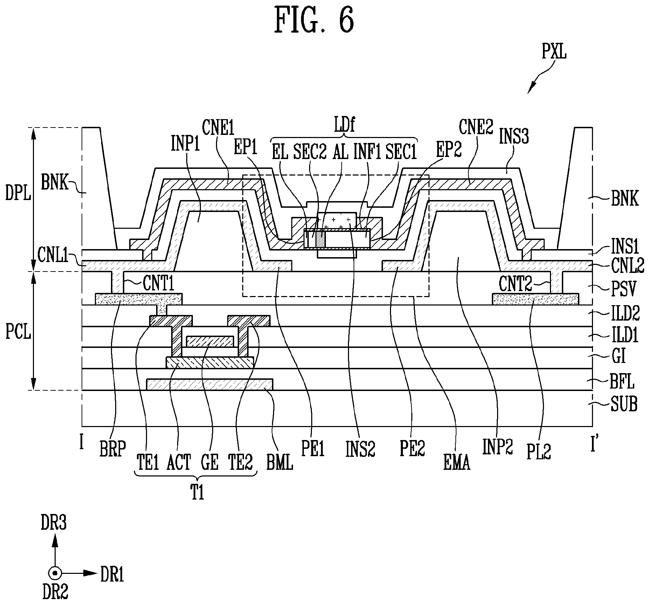

In an embodiment, the first connection electrode CNL1 may be connected to a bridge pattern (e.g., a bridge pattern BRP shown in FIG. 6) of a pixel circuit layer (e.g., a pixel circuit layer PCL shown in FIG. 6) through the first contact part CNT1.

FIG. 6 is a schematic cross-sectional view illustrating an embodiment taken along line I-I' shown in FIG. 5.

Referring to FIGS. 4, 5, and 6, a pixel PXL may include a substrate SUB, a pixel circuit layer PCL, and a display element layer DPL. Hereinafter, for convenience of description, the first transistor T1 among the first to third transistors T1 to T3 described above will be described.

In an embodiment, the substrate SUB may constitute a base member of the display device. The substrate SUB may be a rigid or flexible substrate or film, but the disclosure is not limited thereto. For example, the substrate SUB may include polyimide. The substrate SUB may be provided as a base surface, so that the pixel circuit layer PCL and the display element layer DPL are disposed on the substrate SUB.

In an embodiment, the pixel circuit layer PCL may be disposed on the substrate SUB. The pixel circuit layer PCL may include a lower electrode layer BML, a buffer layer BFL, a first transistor T1, a gate insulating layer GI, a first interlayer insulating layer ILD1, a second interlayer insulating layer ILD2, a bridge pattern BRP, a second power line PL2, a protective layer PSV, a first contact part CNT1, and a second contact part CNT2.

In an embodiment, the lower electrode layer BML may be disposed on the substrate SUB, and may be covered by the buffer layer BFL. A portion of the lower electrode layer BML may overlap the first transistor T1 in a plan view.

In an embodiment, the lower electrode layer BML may include a conductive material, thereby serving as a path through which an electrical signal provided to the pixel circuit layer PCL and the display element layer DPL moves. For example, the lower electrode layer BML may include at least one of aluminium (Al), copper (Cu), titanium (Ti), and molybdenum (Mo).

In an embodiment, the buffer layer BFL may be disposed on the substrate SUB. The buffer layer BFL may prevent an impurity from being diffused from the outside. The buffer layer BFL may include at least one of silicon nitride (SiNx), silicon oxide (SiOx), silicon oxynitride (SiOxNy), and metal oxide such as aluminium oxide (AlOx).

In an embodiment, the first transistor T1 may be electrically connected to a light emitting element LD. The first transistor T1 may be electrically connected to the bridge pattern BRP. However, the disclosure is not limited to the above-described embodiment. The first transistor T1 may be electrically connected to a first connection electrode CNL1 without passing through the bridge pattern BRP.

In an embodiment, the first transistor T1 may include an active layer ACT, a first transistor electrode TE1, a second transistor electrode TE2, and a gate electrode GE.

In an embodiment, the active layer ACT may be a semiconductor layer. The active layer ACT may be disposed on the buffer layer BFL. For example, the active layer ACT may include at least one of Low Temperature Polycrystalline Silicon (LTPS), poly-silicon, amorphous silicon, and an oxide semiconductor.

In an embodiment, the active layer ACT may include a first contact region in contact with the first transistor electrode TE1 and a second contact region in contact with the second transistor electrode TE2. The first contact region and the second contact region may each be a semiconductor pattern doped with an impurity. A region between the first contact region and the second contact region may be a channel region. The channel region may be an intrinsic semiconductor pattern undoped with an impurity.

In an embodiment, the gate electrode GE may be disposed on the gate insulating layer GI. A position of the gate electrode GE may correspond to that of the channel region of the active layer ACT. For example, the gate electrode GE may be disposed on the channel region of the active layer ACT with the gate insulating layer GI interposed therebetween. In an example, the gate electrode GE may include at least one of aluminium (Al), copper (Cu), titanium (Ti), and molybdenum (Mo).

In an embodiment, the gate insulating layer GI may be disposed on the active layer ACT. The gate insulating layer GI may include an inorganic material. For example, the gate insulating layer GI may include at least one of silicon nitride (SiNx), silicon oxide (SiOx), silicon oxynitride (SiOxNy), and aluminium oxide (AlOx).

In an embodiment, the first interlayer insulating layer ILD1 may be disposed on the gate electrode GE. Like the gate insulating layer GI, the first interlayer insulating layer ILD1 may include at least one of silicon nitride (SiNx), silicon oxide (SiOx), silicon oxynitride (SiOxNy), and aluminium oxide (AlOx).

In an embodiment, the first transistor electrode TE1 and the second transistor electrode TE2 may be disposed on the first interlayer insulating layer ILD1. The first transistor electrode TE1 may be in contact with the first contact region of the active layer ACT while penetrating the gate insulating layer GI and the first interlayer insulating layer ILD1, and the second transistor electrode TE2 may be in contact with the second contact region of the active layer ACT while penetrating the gate insulating layer GI and the first interlayer insulating layer ILD1. For example, the first transistor electrode TE1 may be a drain electrode, and the second transistor electrode TE2 may be a source electrode. However, the disclosure is not limited thereto.

In an embodiment, the second interlayer insulating layer ILD2 may be disposed on the first transistor electrode TE1 and the second transistor electrode TE2. Like the first interlayer insulating layer ILD1 and the gate insulating layer GI, the second interlayer insulating layer ILD2 may include an inorganic material. The inorganic material may include at least one of the materials that may be used for the first interlayer insulating layer ILD1 and the gate insulating layer GI, e.g., silicon nitride (SiNx), silicon oxide (SiOx), silicon oxynitride (SiOxNy), and aluminium oxide (AlOx).

In an embodiment, the bridge pattern BRP may be disposed on the second interlayer insulating layer ILD2. The bridge pattern BRP may be connected to the first transistor electrode TE1 through a contact hole penetrating the second interlayer insulating layer ILD2. The bridge pattern BRP may be electrically connected to the first connection electrode CNL1 through the first contact part CNT1 formed in the protective layer PSV.

In an embodiment, the second power line PL2 may be disposed on the second interlayer insulating layer ILD2. The second power line PL2 may be electrically connected to a second connection electrode CNL2 through the second contact part CNT2 formed in the protective layer PSV. The second power line PL2 may provide a second power source (or cathode signal) to the light emitting element LD through a second pixel electrode PE2.

In an embodiment, the protective layer PSV may be disposed on the second interlayer insulating layer ILD2. The protective layer PSV may cover the bridge pattern BRP and the second power line PL2. The protective layer PSV may be a via layer.

In an embodiment, the protective layer PSV may be provided in a form including an organic insulating layer, an inorganic insulating layer, or the organic insulating layer disposed on the inorganic insulating layer, but the disclosure is not limited thereto.

In an embodiment, the first contact part CNT1 connected to a region of the bridge pattern BRP and the second contact part CNT2 connected to a region of the second power line PL2 may be formed in the protective layer PSV.

In an embodiment, the display element layer DPL may be disposed on the pixel circuit layer PCL. The display element layer DPL may include a first insulating pattern INP1, a second insulating pattern INP2, a bank BNK, a first connection electrode CNL1, a second connection electrode CNL2, a first pixel electrode PE1, a second pixel electrode PE2, a first insulating layer INS1, a light emitting element LD (a first light emitting element LDf), a second insulating layer INS2, a first contact electrode CNE1, a second contact electrode CNE2, and a third insulating layer INS3.

In an embodiment, the first insulating pattern INP1 and the second insulating pattern INP2 may be disposed on the protective layer PSV. The first insulating pattern INP1 and the second insulating pattern INP2 may have a shape protruding in a display direction of the display device (e.g., a third direction DR3). For example, the first insulating pattern INP1 and the second insulating pattern INP2 may include an organic material and/or an inorganic material, but the disclosure is not limited thereto.

In an embodiment, the first connection electrode CNL1 and the second connection electrode CNL2 may be disposed on the protective layer PSV. The first connection electrode CNL1 may be connected to the first pixel electrode PE1. The first connection electrode CNL1 may be electrically connected to the bridge pattern BRP through the first contact part CNT1. The first connection electrode CNL1 may electrically connect the bridge pattern BRP and the first pixel electrode PE1 to each other. The second connection electrode CNL2 may be connected to the second pixel electrode PE2. The second connection electrode CNL2 may electrically connected to the second power line PL2 through the second contact part CNT2. The second connection electrode CNL2 may electrically connect the second power line PL2 and the second pixel electrode PE2.

In an embodiment, the first pixel electrode PE1 and the second pixel electrode PE2 may be disposed on the protective layer PSV. In accordance with an embodiment, at least a portion of the first pixel electrode PE1 may be arranged on the first insulating pattern INP1, at least a portion of the second pixel electrode PE2 may be arranged on the second insulating pattern INP2, and each may function as a reflective partition wall.

In an embodiment, the first pixel electrode PE1 may be electrically connected to a first light emitting element LDf. The first pixel electrode PE1 may be electrically connected to the first contact electrode CNE1 through a contact hole formed in the first insulating layer INS1. The first pixel electrode PE1 may provide an anode signal to the first light emitting element LDf.

In an embodiment, the second pixel electrode PE2 may be electrically connected to the first light emitting element LDf. The second pixel electrode PE2 may be electrically connected to the second contact electrode CNE2 through a contact hole formed in the first insulating layer INS1. The second pixel electrode PE2 may apply a cathode signal (e.g., a ground signal) to the first light emitting element LDf.

In an embodiment, the first pixel electrode PE1 and the second pixel electrode PE2 may include a conductive material. For example, the first pixel electrode PE1 and the second pixel electrode PE2 may each include at least one of silver (Ag), magnesium (Mg), aluminium (Al), platinum (Pt), palladium (Pd), gold (Au), nickel (Ni), neodymium (Nd), iridium (Ir), chromium (Cr), titanium (Ti), and alloys thereof. However, the disclosure is not limited to the above-described embodiment.

In an embodiment, the first insulating layer INS1 may be disposed on the protective layer PSV. The first insulating layer INS1 may cover the first pixel electrode PE1 and the second pixel electrode PE2. The first insulating layer INS1 may stabilize connection between electrode components, and reduce external influence. The first insulating layer INS1 may include at least one of silicon oxide (SiOx), silicon nitride (SiNx), silicon oxynitride (SiOxNy), and aluminium oxide (AlOx).

In an embodiment, the bank BNK may be disposed on the first insulating layer INS1. The first light emitting element LDf may be disposed in a space defined by the bank BNK. The bank BNK may have a shape protruding in the display direction of the display device (e.g., the third direction DR3). For example, the bank BNK may include an organic material or an inorganic material, but the disclosure is not limited thereto.

In an embodiment, the first light emitting element LDf may be disposed on the first insulating layer INS1, to emit light, by an electrical signal provided from the first contact electrode CNE1 and the second contact electrode CNE2.

In an embodiment, the first light emitting element LDf included in the light emitting element LD (e.g., the light emitting element LD shown in FIG. 5) may include a first end portion EP1 and a second end portion EP2 as described above.

In an embodiment, the first end portion EP1 of the first light emitting element LDf may be electrically connected to the first contact electrode CNE1. The second end portion EP2 of the first light emitting element LDf may be electrically connected to the second contact electrode CNE2.

In an embodiment, a second semiconductor layer SEC2 of the first light emitting element LDf may be disposed adjacent to the first pixel electrode PE1 and the first contact electrode CNE1, and a first semiconductor layer SEC1 of the first light emitting element LDf may be disposed adjacent to the second pixel electrode PE2 and the second contact electrode CNE2.

In an embodiment, the first light emitting element LDf included in the light emitting element LD may be connected in the forward direction between the first pixel electrode PE1 and the second pixel electrode PE2.

In an embodiment, the second insulating layer INS2 may be disposed on the first light emitting element LDf. The second insulating layer INS2 may cover an active layer AL of the first light emitting element LDf. For example, the second insulating layer INS2 may include an organic material and/or an inorganic material. For example, at least a portion of the second insulating layer INS2 may fill a gap (or cavity) formed at the bottom of the first light emitting element LDf.

In an embodiment, the first contact electrode CNE1 and the second contact electrode CNE2 may be disposed on the first insulating layer INS1. The first contact electrode CNE1 may electrically connect the first pixel electrode PE1 to the first end portion EP1 of the first light emitting element LDf, and the second contact electrode CNE2 may electrically connect the second pixel electrode PE2 to the second end portion EP2 of the first light emitting element LDf.

In an embodiment, the first contact electrode CNE1 may provide an anode signal to the first end portion EP1 of the first light emitting element LDf, and the second contact electrode CNE2 may provide a cathode signal to the second end portion EP2 of the first light emitting element LDf.

In an embodiment, the first contact electrode CNE1 and the second contact electrode CNE2 may include a conductive material. In accordance with an embodiment, the first contact electrode CNE1 and the second contact electrode CNE2 may be formed through the same process, and include the same material. For example, the first contact electrode CNE1 and the second contact electrode CNE2 may include a transparent conductive material such as Indium Tin Oxide (ITO), Indium Zinc Oxide (IZO), and Indium Tin Zinc Oxide (ITZO), but the disclosure is not limited thereto.

In an embodiment, the third insulating layer INS3 may be disposed on the first contact electrode CNE1, the second contact electrode CNE2, and the second insulating layer INS2, to protect components of the display element layer DPL from external influence (e.g., moisture and the like). For example, the third insulating layer INS3 may include at least one of silicon nitride (SiNx), silicon oxide (SiOx), silicon oxynitride (SiOxNy), and aluminium oxide (AlOx).

However, the structure of the pixel PXL is not limited to the embodiment described above with reference to FIG. 6, and various modifiable embodiments may be implemented.

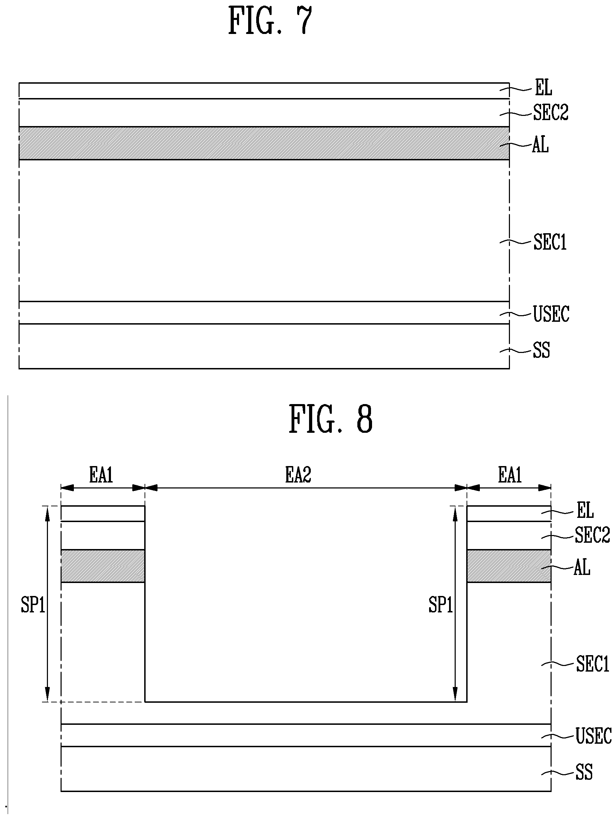

FIGS. 7 to 21 are schematic cross-sectional views illustrating a manufacturing method of the light emitting element in accordance with embodiments of the disclosure.

Referring to FIG. 7, an undoped semiconductor layer USEC may be formed on a stack substrate SS. A first semiconductor layer SEC1, an active layer AL, a second semiconductor layer SEC2, and an electrode layer EL may be sequentially disposed on the undoped semiconductor layer USEC.

In an embodiment, the stack substrate SS may be a base plate for stacking a target material. The stack substrate SS may be a wafer for epitaxial growth of the target material. For example, the stack substrate SS may be a sapphire substrate, a GaAs substrate, a Ga substrate, or an InP substrate, but the disclosure is not limited thereto. For example, in case that a material satisfies a selectivity for manufacturing a first light emitting element LDf, and the epitaxial growth of the target material is readily performed, the material may be selected for the stack substrate SS. The shape of the stack substrate SS may be a polygonal shape such as a rectangular shape or a circular shape, but the disclosure is not limited thereto.

In an embodiment, the undoped semiconductor layer USEC may be a semiconductor layer in which any dopant is not provided so as to suppress occurrence of a defect in a highly doped semiconductor layer of the first semiconductor layer SEC1. For example, the undoped semiconductor layer USEC may include a semiconductor material such as InAlGa, GaN, AlGaN, InGaN, AlN, and InN, and any separate dopant may not be provided in the undoped semiconductor layer USEC. An etch rate of the undoped semiconductor layer USEC in which any dopant is not provided may be different from an etch rate of the first semiconductor layer SEC1.

In an embodiment, the undoped semiconductor layer USEC may be formed through a process such as Metal Organic Chemical Vapor-phase Deposition (MOCVD), Molecular Beam Epitaxy (MBE), Vapor Phase Epitaxy (VPE), and Liquid Phase Epitaxy (LPE).

In an embodiment, the first semiconductor layer SEC1, the active layer AL, and the second semiconductor layer SEC2 may be formed through epitaxial growth, and may be provided through any one of the processes that may be used for forming the undoped semiconductor layer USEC.

In an embodiment, the electrode layer EL may be formed on the second semiconductor layer SEC2. The electrode layer EL may be stacked on the second semiconductor layer SEC2 through a deposition process. The electrode layer EL may minimize loss of light output from the active layer AL to be released to the outside of the light emitting element LD. For example, the electrode layer EL may include a transparent metal oxide so as to improve an effect of current spread to the second semiconductor layer SEC2.

Referring to FIG. 8, the stack substrate SS may include a first area EA1 and a second area EA2.

The first area EA1 may be an area in which a first light emitting element (e.g., the first light emitting element LDf shown in FIG. 1) is formed. The second area EA2 may be an area in which a second light emitting element (e.g., the second light emitting element LDr shown in FIG. 1) is formed.

In an embodiment, a first stack structure SP1 may be formed by etching portions of the first semiconductor layer SEC1, the active layer AL, the second semiconductor layer SEC2, and the electrode layer EL, which correspond to the second area EA2, using a mask (not shown). The etching process for forming the first stack structure SP1 may be a dry etching process. The dry etching process may be Reactive Ion Etching (RIE), Reactive Ion Beam Etching (RIBE), or Inductively Coupled Plasma Reactive Ion Etching (ICP-RIE).

In an embodiment, in case that the first semiconductor layer SEC1, the active layer AL, the second semiconductor layer SEC2, and the electrode layer EL, which correspond to the second area EA2, are removed, the first stack structure SP1 may be formed at both sides of the second area EA2 including the first semiconductor layer SEC1, the active layer AL, the second semiconductor layer SEC2, and the electrode layer EL. The first stack structure SP1 may correspond to a stack structure for forming the first light emitting element (e.g., the first light emitting element LDf shown in FIG. 1).

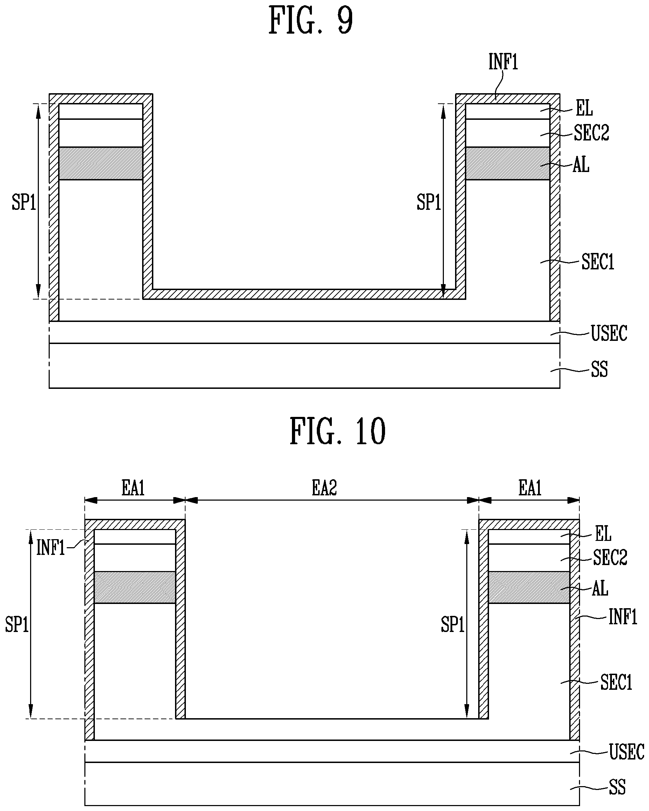

Referring to FIG. 9, a first insulative film INF1 for covering the first semiconductor layer SEC1, the active layer AL, the second semiconductor layer SEC2, and the electrode layer EL may be formed. For example, the first insulative film INF1 may be integrally formed on the first and second areas EA1 and EA2, and cover the first stack structure SP1.

Referring to FIG. 10, a portion of the first insulative film INF1, which corresponds to the second area EA2, may be removed. The first insulative film INF1 may cover only the first stack structure SP1.

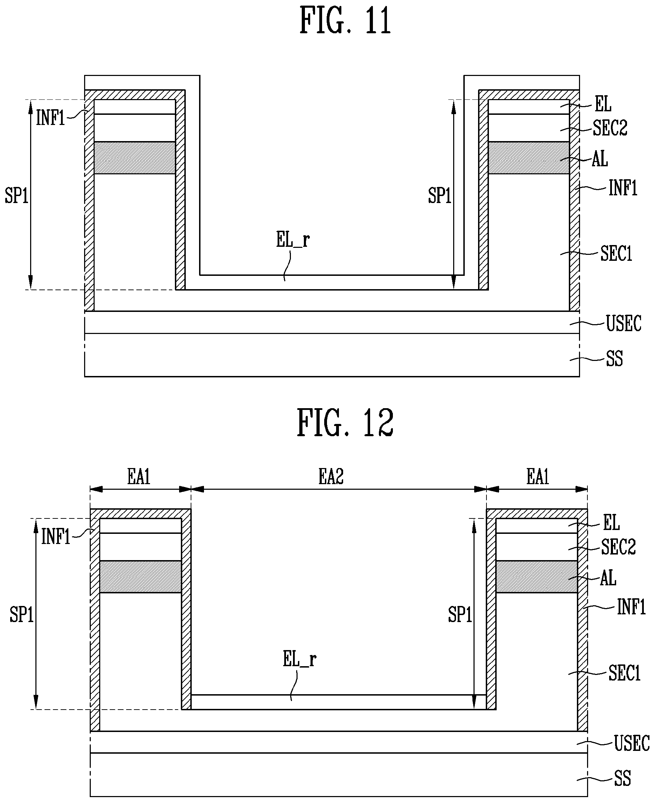

Referring to FIGS. 11 and 12, after an electrode layer EL_r is entirely deposited on an area corresponding to the first area EA1 and the second area EA2, a portion of the electrode layer EL_r, which corresponds to the first area EA1, may be removed.

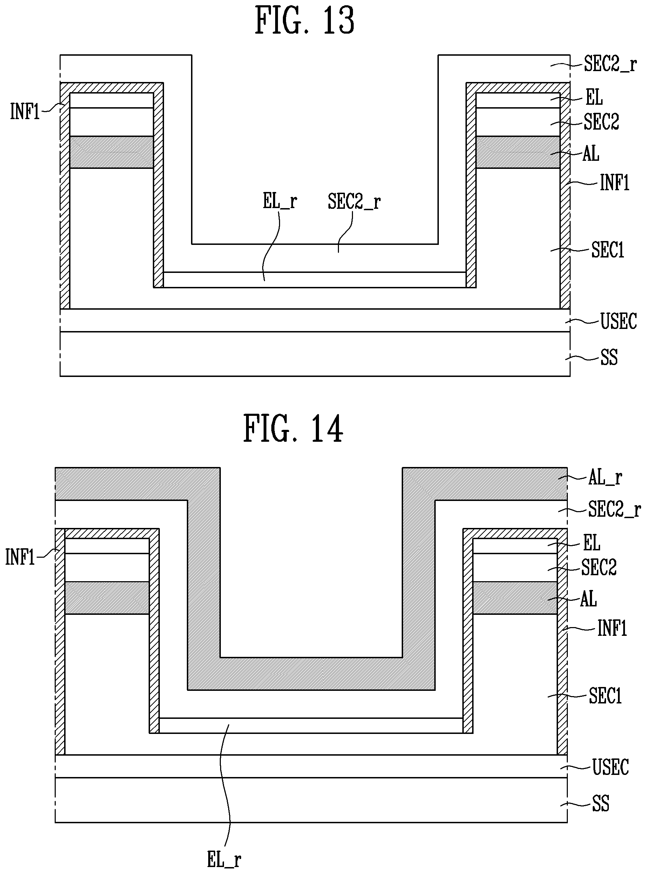

Referring to FIGS. 13 to 15, a second semiconductor layer SEC2_r, an active layer AL_r, and a first semiconductor layer SEC1_r may be sequentially formed on the first insulative film INF1 and the electrode layer EL_r. The active layer AL_r may be disposed on the second semiconductor layer SEC2_r, and the first semiconductor layer SEC1_r may be disposed on the active layer AL_r. For example, a process of forming the first semiconductor layer SEC1_r, the active layer AL_r, and the second semiconductor layer SEC2_r may be identical to the process of forming the first semiconductor layer SEC1, the active layer AL, and the second semiconductor layer SEC2, described with reference to FIG. 7. For example, the first semiconductor layer SEC1_r, the active layer AL_r, and the second semiconductor layer SEC2_r may be formed through epitaxial growth, and may be provided through any one of the processes that may be used for forming the undoped semiconductor layer USEC.

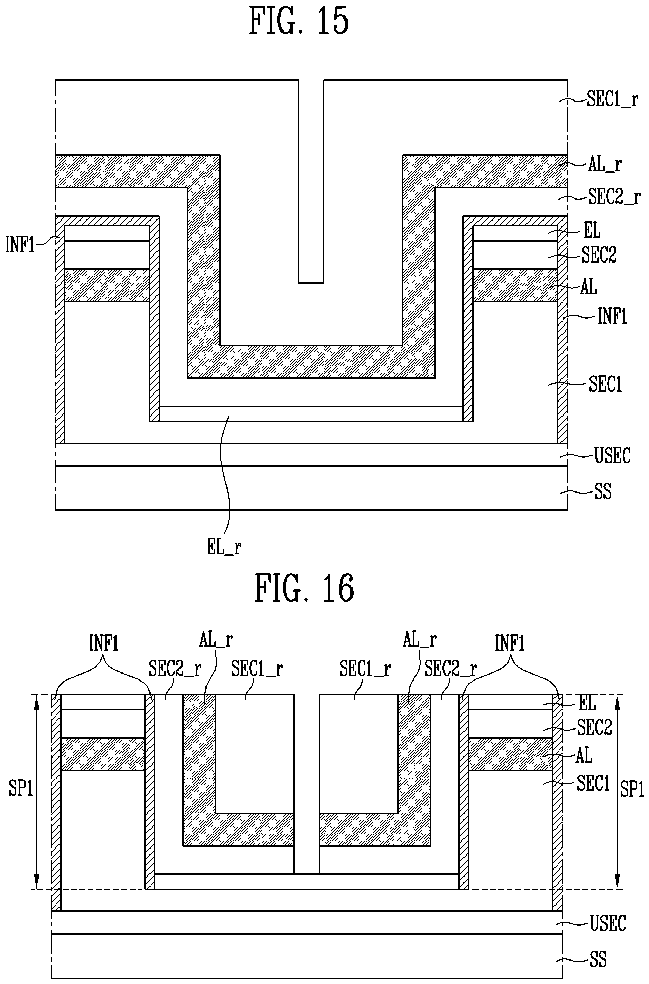

Referring to FIG. 16, a portion of the second area EA2 and the first semiconductor layer SEC1_r, the active layer AL_r, the second semiconductor layer SEC2_r and the first insulative film INF1 on the first stack structure SP1 may be removed. The first semiconductor layer SEC1_r, the active layer AL_r, the second semiconductor layer SEC2_r, and the first insulative film INF1, which are disposed on the electrode layer EL, may be removed by etching.

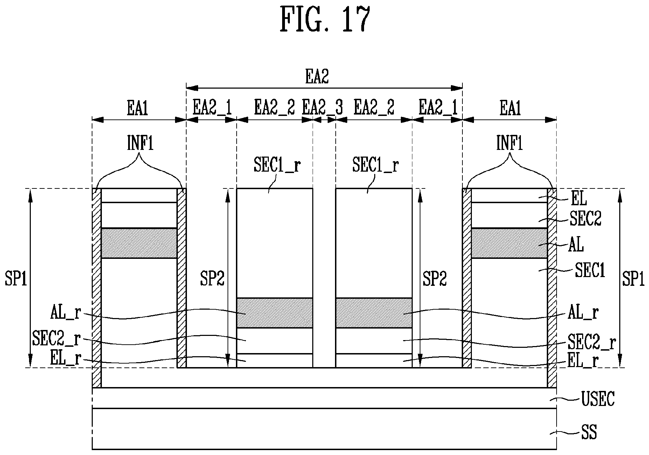

Referring to FIG. 17, the stack substrate SS may include the first area EA1 in which the first light emitting element (e.g., the first light emitting element LDf shown in FIG. 1) is formed and the second area EA2 in which the second light emitting element (e.g., the second light emitting element LDr shown in FIG. 1) is formed. The second area EA2 in which the second light emitting element LDr is formed may include a (2_1)th area EA2_1, a (2_2)th area EA2_2, and a (2_3)th area EA2_3. The (2_2)th area EA2_2 may be an area in which a second stack structure SP2 of the second light emitting element LDr is formed. The (2_1)th area EA2_1 and the (2_3)th area EA2_3 may be an area in which a second insulative film INF2 is filled.

In an embodiment, the (2_1)th area EA2_1 may have the same width as the first area EA1 in which the first light emitting element LDf is formed.

For example, areas of the first semiconductor layer SEC1_r, the active layer AL_r, the second semiconductor layer SEC2_r, and the electrode layer EL_r, which correspond to the (2_1)th area EA2_1 and the (2_3)th area EA2_3, may be removed by using a mask (not shown). For example, in case that the first semiconductor layer SEC1_r, the active layer AL_r, the second semiconductor layer SEC2_r, and the electrode layer EL_r, which correspond to the (2_1)th area EA2_1 and the (2_3)th area EA2_3, are removed, the second stack structure SP2 may be formed including the electrode layer EL_r, the second semiconductor layer SEC2_r, the active layer AL_r, and the first semiconductor layer SEC1_r, which are sequentially stacked in the (2_2)th area EA2_2. The second stack structure SP2 may correspond to a stack structure for forming the second light emitting element (e.g., the second light emitting element LDr shown in FIG. 1).

In an embodiment, two second stack structures SP2 may be formed in the second area EA2. The two second stack structure SP2 may be disposed between the first stack structures SP1.

In an embodiment, the second semiconductor layer SEC2 of the first stack structure SP1 and the first semiconductor layer SEC1_r of the second stack structure SP2 may be disposed in the same layer (plane).

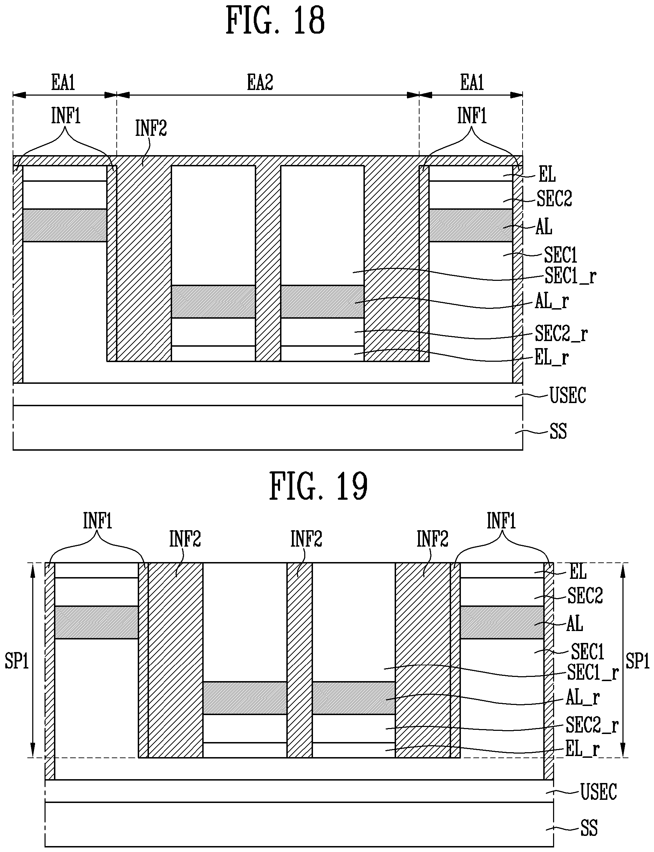

Referring to FIG. 18, the second insulative film INF2 for covering the first insulative film INF1, the first semiconductor layer SEC1_r, the active layer AL_r, the second semiconductor layer SEC2_r, and the electrode layer EL_r may be formed. The second insulative film INF2 may be entirely deposited in an area corresponding to the first area EA1 and the second area EA2.

Referring to FIGS. 17 and 19, the second insulative film INF2 on the first stack structure SP1 and the second stack structure SP2 may be removed. The second insulative film INF2 and the first insulative film INF1 may have the same height.

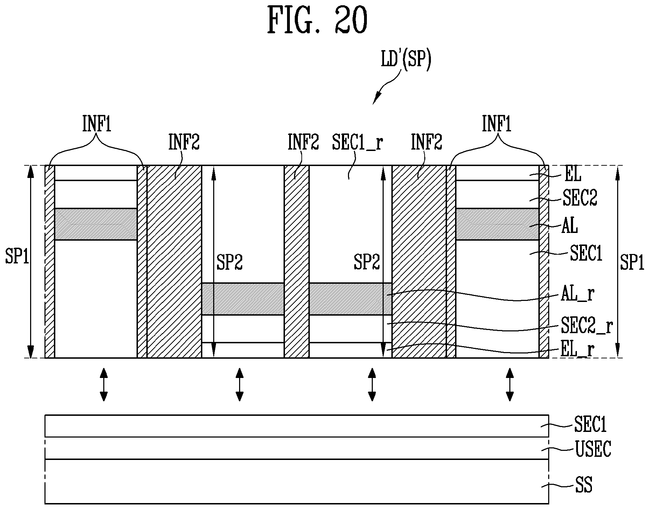

Referring to FIG. 20, a light emitting stack pattern SP may provide a light emitting element LD' by separating from a portion of the first semiconductor layer SEC1, the stack substrate SS, and the undoped semiconductor layer USEC. The light emitting stack pattern SP separated from the stack substrate SS and the undoped semiconductor layer USEC may be provided as the light emitting element LD'. The light emitting stack pattern SP may include a first stack structure SP1 and a second stack structure SP2. The first stack structure SP1 may be a stack structure for forming the first light emitting element LDf, and the second stack structure SP2 may be a stack structure for forming the second light emitting element LDr.

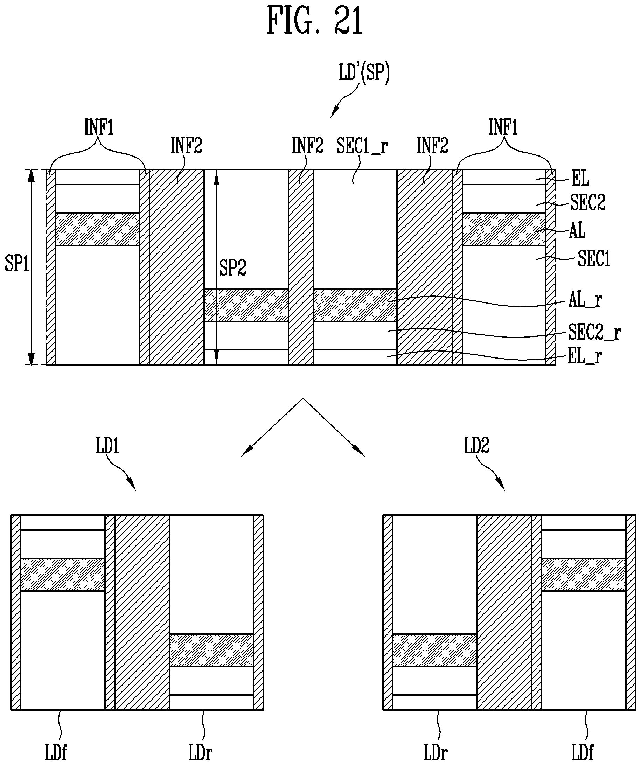

Referring to FIG. 21, the light emitting stack pattern SP provided as the light emitting element LD' may include multiple first light emitting elements LDf and multiple second light emitting elements LDr. The light emitting stack pattern SP provided as the light emitting element LD' may be separated into a first light emitting element unit LD1 and a second light emitting element unit LD2. Each of the first light emitting element unit LD1 and the second light emitting element unit LD2 may include a first light emitting element LDf and a second light emitting element LDr. The first light emitting element unit LD1 and the second light emitting element unit LD2 may be provided as the light emitting element LD shown in FIG. 1.

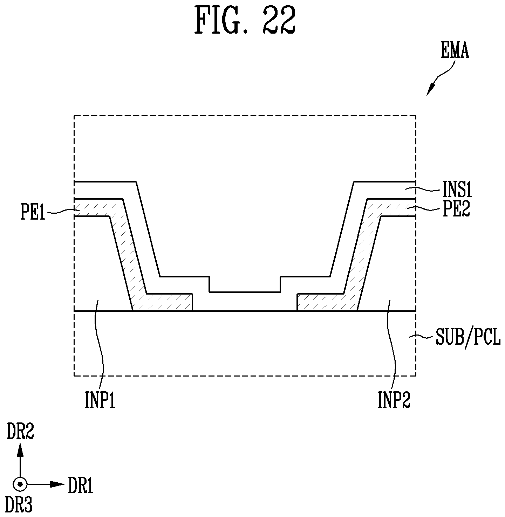

FIGS. 22 to 26 are schematic cross-sectional views illustrating a manufacturing method of the display device in accordance with embodiments of the disclosure.

FIGS. 22 to 24 are schematic cross-sectional views illustrating the emission area EMA shown in FIG. 7, and are schematic sectional views illustrating processes of a manufacturing method of the display device in accordance with embodiments of the disclosure.

Referring to FIG. 22, a substrate SUB may be provided, and a pixel circuit layer PCL may be disposed on the substrate SUB. A first insulating pattern INP1 and a second insulating pattern INP2 may be disposed on the pixel circuit layer PCL, a first pixel electrode PE1 and a second pixel electrode PE2 may be disposed over the first insulating pattern INP1 and the second insulating pattern INP2, respectively, and a first insulating layer INS1 may be disposed over the first pixel electrode PE1 and the second pixel electrode PE2.

Individual components of the pixel circuit layer PCL, which are disposed on the substrate SUB, may be formed by patterning a conductive layer (or metal layer), an inorganic material, an organic material, or the like through an ordinary process using a mask.

The first insulating pattern INP1 and the second insulating pattern INP2 may be formed (or deposited) on the pixel circuit layer PCL. In accordance with an embodiment, the first insulating pattern INP1 and the second insulating pattern INP2 may have a shape protruding in the display direction (e.g., the third direction DR3) such that a reflective surface can be formed.

Although not shown in drawings, the first pixel electrode PE1 and the second pixel electrode PE2 may be formed by etching at least a portion of a base electrode after the base electrode is deposited on the pixel circuit layer PCL.

The first pixel electrode PE1 and the second pixel electrode PE2 may be formed to respectively cover the first insulating pattern INP1 and the second insulating pattern INP2. Accordingly, at least a portion of each of the first pixel electrode PE1 and the second pixel electrode PE2 may be provided as a reflective partition wall or a reflective bank.

The first insulating layer INS1 may be formed (or deposited) to cover the first pixel electrode PE1 and the second pixel electrode PE2.

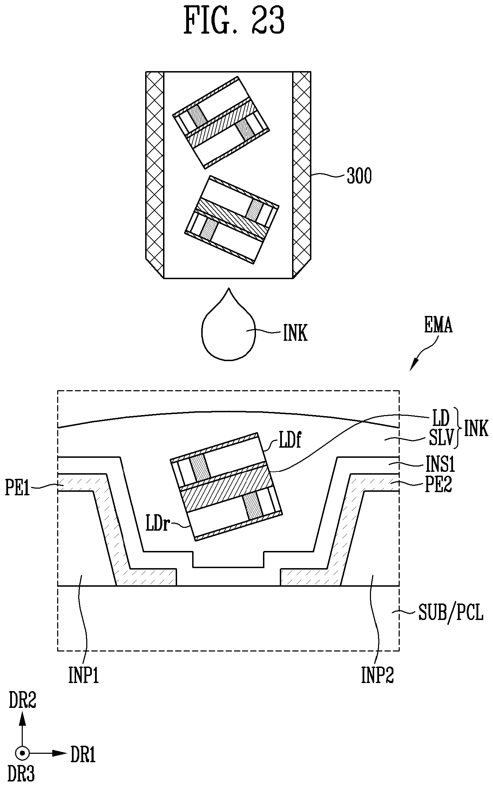

Referring to FIG. 23, an ink INK may be provided on the substrate SUB. The ink INK may be provided by a printing apparatus 300 capable of providing (or spraying) fluid.

In accordance with an embodiment, the printing apparatus 300 may include a nozzle part configured to release fluid to the outside. The ink INK in this specification may be a liquid mixture which can be released by the printing apparatus 300.

The printing apparatus 300 may spray the ink INK onto an area in which light emitting elements LD are to be arranged.

In accordance with an embodiment, the ink INK may include a solvent SLV and a light emitting element LD. Multiple light emitting element LD may be provided in the ink INK, to be dispersed in the solvent SLV having liquidity. For example, the solvent SLV may be a liquid-phase material, instead of a solid-phase material, in which the light emitting elements LD may be dispersed.

The ink INK may be accommodated in a predetermined (or selectable) area. For example, the ink INK may be provided in an area (or space) defined by a bank BNK.

The light emitting element LD may be provided to be randomly oriented. In an embodiment, the light emitting element LD may be provided as a light emitting element unit in which a first light emitting element LDf and a second light emitting element LDr are integrally formed.

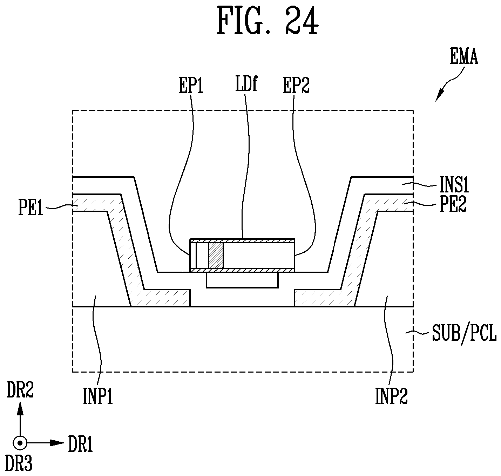

Referring to FIG. 24, the light emitting element LD may be arranged between the first pixel electrode PE1 and the second pixel electrode PE2.

The light emitting element LD may be moved to an area in which the light emitting element LD is to be disposed by a dielectrophoresis (DEP) force generated by an electrical signal provided to the first pixel electrode PE1 and the second pixel electrode PE2. Accordingly, the first light emitting element LDf and the second light emitting element LDr, which are included in the light emitting element LD, may be integrally disposed between the first pixel electrode PE1 and the second pixel electrode PE2.

Electrical signal may be provided to the first pixel electrode PE1 and the second pixel electrode PE2, so that an electric field is formed between the first pixel electrode PE1 and the second pixel electrode PE2.

In accordance with an embodiment, a first electrical signal may be provided to the first pixel electrode PE1, and a second electrical signal may be provided to the second pixel electrode PE2. The light emitting element LD may be arranged in response to an electric field by the first electrical signal and the second electrical signal. For example, each of the first electrical signal and the second electrical signal may be AC signal, and may be any one of a sine wave, a triangular wave, a square wave, a trapezoidal wave, and a pulse wave. However, the disclosure is not limited to a specific embodiment.

One of the first light emitting element LDf and the second light emitting element LDr, which are included in the light emitting element LD, may be arranged in the forward direction, and another one of the first light emitting element LDf and the second light emitting element LDr may be arranged in the reverse direction. For example, a second semiconductor layer SEC2 of the first light emitting element LDf and a first semiconductor layer SEC1_r of the second light emitting element LDr may be disposed to face the first pixel electrode PE1, and a first semiconductor layer SEC1 of the first light emitting element LDf and a second semiconductor layer SEC2_r of the second light emitting element LDr may be disposed to face the second pixel electrode PE2. The first light emitting element LDf may be arranged in the forward direction, and the second light emitting element LDr may be arranged in the reverse direction.

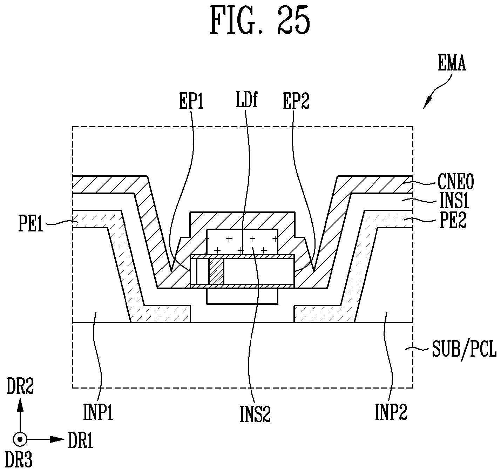

Referring to FIG. 25, a second insulating layer INS2 may be disposed on the first light emitting element LDf (and the second light emitting element LDr), and a base contact electrode CNE0 may be disposed on the first insulating layer INS1 and the second insulating layer INS2.

The second insulating layer INS2 may be disposed to overlap an active layer AL of the first light emitting element LDf in a plan view.

The base contact electrode CNE0 may cover the first insulating layer INS1 and the second insulating layer INS2. The base contact electrode CNE0 may be electrically connected to the first light emitting element LDf. For example, a portion of the base contact electrode CNE0 may overlap a first end portion of the first light emitting element LDf in a plan view, and another portion of the base contact electrode CNE0 may overlap a second end portion EP2 of the first light emitting element LDf in a plan view.

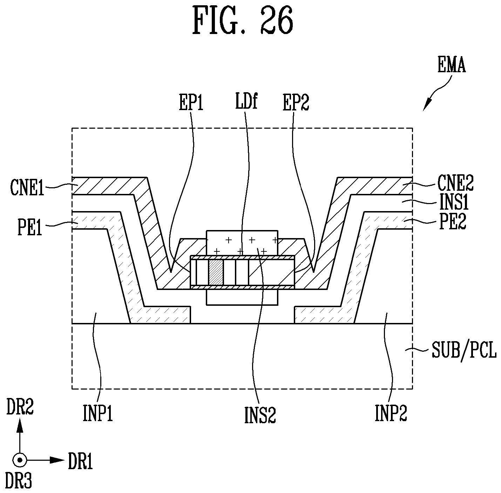

Referring to FIG. 26, a first contact electrode CNE1 and a second contact electrode CNE2 may be formed by etching at least a portion of the base contact electrode CNE0.

In this phase, as at least a portion of the base contact electrode CNE0 is removed, at least a portion of the second insulating layer INS2 may be exposed, and the first contact electrode CNE1 and the second contact electrode CNE2, which are spaced apart from each other, may be formed.

In accordance with an embodiment, the first contact electrode CNE1 and the second contact electrode CNE2 may be formed as portions of the base contact electrode CNE0 at the same time. Accordingly, the first contact electrode CNE1 and the second contact electrode CNE2 may include the same material.

The first contact electrode CNE1 may be electrically connected to the second semiconductor layer SEC2 of the first light emitting element LDf, and the second contact electrode CNE2 may be electrically connected to the first semiconductor layer SEC1 of the first light emitting element LDf. For example, the first light emitting element LDf may form an effective light source of the light emitting element LD.

One of the first light emitting element LDf and the second light emitting element LDr, which are included in the light emitting element LD, may be disposed as an effective light source between the first pixel electrode PE1 and the second pixel electrode PE2, and thus a light emitting element forming a constant effective light source in the pixel PXL can be secured. A light emitting element uniformly forming an effective light source between multiple pixels PXL can be secured.

Although not shown in FIG. 26, a third insulating layer INS3 may be disposed (or formed) over the first contact electrode CNE1 and the second contact electrode CNE2, thereby forming a display element layer DPL. In some embodiments, a color conversion layer CCL, an optical layer OPL, a color filter layer CFL, and the like may be formed on the display element layer DPL, thereby forming the display device in accordance with the embodiments of the disclosure.

The above description is an example of technical features of the disclosure, and those skilled in the art to which the disclosure pertains will be able to make various modifications and variations. Therefore, the embodiments of the disclosure described above may be implemented separately or in combination with each other.

Therefore, the embodiments disclosed in the disclosure are not intended to limit the technical spirit of the disclosure, but to describe the technical spirit of the disclosure, and the scope of the technical spirit of the disclosure is not limited by these embodiments.

## Claims

1. A light emitting element comprising:
a first light emitting element including a first semiconductor layer, an active layer, and a second semiconductor layer, which are sequentially disposed in a first direction;
a second light emitting element including a first semiconductor layer, an active layer, and a second semiconductor layer, which are spaced apart from the first light emitting element and sequentially disposed in a reverse direction of the first direction; and
an insulative film surrounding a portion of the first light emitting element and a portion of the second light emitting element.

2. The light emitting element of claim 1, wherein the insulative film surrounds at least a portion of an outer circumferential surface of the first light emitting element and at least a portion of an outer circumferential surface of the second light emitting element, and fills a space between the first light emitting element and the second light emitting element.

3. The light emitting element of claim 2, wherein the insulative film includes a first insulative film surrounding at least a portion of the outer circumferential surface of the first light emitting element and a second insulative film which surrounds at least a portion of the outer circumferential surface of the second light emitting element and fills the space between the first light emitting element and the second light emitting element.

4. The light emitting element of claim 3, wherein the first insulative film and the second insulative film include a same material.

5. The light emitting element of claim 2, further comprising an electrode layer disposed on the second semiconductor layer of the first light emitting element and the second semiconductor layer of the second light emitting element.

6. The light emitting element of claim 5, wherein each of the first light emitting element and the second light emitting element includes a first end portion and a second end portion, and
wherein each of the electrode layer is disposed on the first end portion of each of the first light emitting element and the second light emitting element, respectively, and each of the first semiconductor layer is disposed on the second end portion of each of the first light emitting element and the second light emitting element, respectively.

7. The light emitting element of claim 6, wherein the insulative film exposes each of the first end portion and the second end portion of each of the first light emitting element and the second light emitting element.

8. The light emitting element of claim 6, wherein the first end portion of the first light emitting element and the second end portion of the second light emitting element are disposed on a same plane.

9. The light emitting element of claim 1, wherein the second light emitting element is spaced apart from the first light emitting element in a second direction intersecting the first direction.

10. The light emitting element of claim 1, wherein shapes of the first light emitting element and the second light emitting element are same.

11. The light emitting element of claim 1, wherein each of the first semiconductor layer includes GaN doped with an n-type dopant, and
each of the second semiconductor layer includes GaN doped with a p-type dopant.

12. A method of manufacturing a light emitting element, the method comprising:
forming an undoped semiconductor layer on a stack substrate including a first area and a second area;
sequentially forming a first semiconductor layer, an active layer, a second semiconductor layer, and an electrode layer on the undoped semiconductor layer;
forming a first stack structure in the first area by removing a portion of each of the first semiconductor layer, the active layer, the second semiconductor layer, and the electrode layer, which correspond to the second area;
forming a first insulative film covering the first stack structure including the first semiconductor layer, the active layer, the second semiconductor layer, and the electrode layer;
sequentially forming an electrode layer, a second semiconductor layer, an active layer, and a first semiconductor layer in the first area and the second area;
forming a second stack structure by removing a portion of each of the first semiconductor layer, the active layer, the second semiconductor layer, and the electrode layer in the second area and on the first stack structure; and
forming a second insulative film covering at least a portion of a side surface of the second stack structure.

13. The method of claim 12, wherein the forming of the second insulative film includes:
forming the second insulative film on an entire area of the first area and the second area; and
removing the second insulative film disposed on a top surface of the first stack structure and a top surface of the second stack structure.

14. The method of claim 12, wherein the forming of the first insulative film includes:
forming the first insulative film on an entire area of the first area and the second area; and
removing the first insulative film of the second area.

15. The method of claim 12, wherein the second semiconductor layer of the first stack structure and the first semiconductor layer of the second stack structure are disposed in a same plane.

16. The method of claim 12, wherein the forming of the second stack structure includes removing the first insulative film formed on the electrode layer of the first stack structure.

17. The method of claim 12, further comprising forming a light emitting stack pattern by separating the first stack structure, the second stack structure, the first insulative film, and the second insulative film from the stack substrate and the undoped semiconductor layer.

18. The method of claim 12, wherein the forming of the second stack structure includes forming two second stack structures in the second area.

19. A pixel comprising:
a first pixel electrode and a second pixel electrode, each disposed on a substrate;
light emitting elements disposed on the first pixel electrode and the second pixel electrode;
a first contact electrode electrically connecting the first pixel electrode and the light emitting elements to each other; and
a second contact electrode electrically connecting the second pixel electrode and the light emitting elements to each other,
wherein each of the light emitting elements includes a first light emitting element arranged in a first direction, a second light emitting element arranged in a second direction that is a reverse direction of the first direction, and an insulative film coupling the first light emitting element and the second light emitting element.

20. The pixel of claim 19, wherein the first light emitting element includes a first semiconductor layer, an active layer, a second semiconductor layer, and an electrode layer, which are sequentially disposed in the first direction, and
the second light emitting element includes a first semiconductor layer, an active layer, a second semiconductor layer, and an electrode layer, which are sequentially disposed in the second direction.

21. The pixel of claim 20, wherein each of the first light emitting element and the second light emitting element includes a first end portion and a second end portion, and
each of the electrode layer is disposed on the first end portion of each of the first light emitting element and the second light emitting element, respectively, and each of the first semiconductor layer is disposed on the second end portion of each of the first light emitting element and the second light emitting element, respectively.

22. The pixel of claim 21, wherein the first end portion of the first light emitting element and the second end portion of the second light emitting element electrically contact the first contact electrode, and
the second end portion of the first light emitting element and the first end portion of the second light emitting element electrically contact the second contact electrode.
